# EUROPEAN PATENT APPLICATION

(11) **EP 4 770 334 A1**
(43) Date of publication of application: **01.07.2026**
(21) Application number: 25218449.4
(22) Date of filing: 25.11.2025
(51) Int. Cl.: H10D 84/01, H10D 30/01, H10D 30/00, H10D 62/832, H10D 84/83, H10D 84/85

(54) **ASYMMETRIC STACKS OF NMOS AND PMOS TRANSISTORS IN A HYBRID CMOS ARCHITECTURE**

(30) Priority: 27.12.2024 US 202419003124
(71) Applicant: Intel Corporation, Santa Clara, CA 95054 (US)
(72) Inventor: CHOUKSEY, Siddharth, Portland 97229 (US); DEWEY, Gilbert, Beaverton 97006 (US); HATTENDORF, Michael, Portland 97229 (US); AGRAWAL, Ashish, Hillsboro 97124 (US); GHOSE, Susmita, Hillsboro 97124 (US)
(74) Representative: 2SPL Patentanwälte PartG mbB

(57) **Abstract**

An apparatus provides NMOS and PMOS transistors having asymmetric stacks. The apparatus includes a first transistor and a second transistor on a base layer. The first transistor includes first channel regions that include a first element, a first gate region around the first channel regions, and a first source region and a first drain region at opposite ends of the first channel regions. The second transistor includes second channel regions that include a second element, a second gate region around the second channel regions, and a second source region and a second drain region at opposite ends of the second channel regions. The first channel regions are not coplanar with the second channel regions. In some scenarios, the number of first channel regions in the first transistor is unequal to the number of second channel regions in the second transistor.

## Description

### BACKGROUND

Hybrid CMOS (complementary metal oxide semiconductor) architecture combines both NMOS (n-type metal oxide semiconductor) and PMOS (p-type metal oxide semiconductor) transistors on a single integrated circuit. For example, a hybrid germanium/silicon (Ge/Si) CMOS fabrication can integrate germanium, which has a high p-type mobility, with n-type silicon in transistors on a chip in order to leverage the advantages of both materials. It is desirable for PMOS and NMOS materials to have a similar drive capacity or drivability, which involves the ability to provide current and to charge and discharge capacitive loads.

### BRIEF DESCRIPTION OF THE DRAWINGS

FIGS. 1A-1D are perspective views of example planar, FinFET, gate-all-around, and stacked gate-all-around transistors.
FIGS. 2A is a top view of an example hybrid CMOS architecture with n-type metal oxide semiconductor (NMOS) transistors and p-type metal oxide semiconductor (PMOS) transistors according to at least one embodiment.
FIGS. 2B-2D are various cross-sectional views of FIG. 2A.
FIGS. 3A-3E illustrate an example process of forming gate-all-around transistors with example asymmetric nanoribbon stacks in accordance with at least one embodiment.
FIGS. 4A-4E illustrate another example process of forming gate-all-around transistors with other example asymmetric nanoribbon stacks in accordance with at least one embodiment.
FIG. 5 is an example method for making NMOS and PMOS transistors having asymmetric nanoribbon stacks according to at least one embodiment.
FIG. 6 is a top view of a wafer and dies that may be included in a microelectronic assembly, in accordance with any of the embodiments disclosed herein.
FIG. 7 is a cross-sectional view of an integrated circuit device that may be included in any of the microelectronic assemblies disclosed herein.
FIG. 8 is a cross-sectional view of an integrated circuit device assembly that may include a microelectronic assembly, in accordance with any of the embodiments disclosed herein.
FIG. 9 is a block diagram of an example electrical device that may include a microelectronic assembly, in accordance with any of the embodiments disclosed herein.

### DETAILED DESCRIPTION

In the following description, specific details are set forth, but embodiments of the technologies described herein may be practiced without these specific details. Well-known circuits, structures, and techniques have not been shown in detail to avoid obscuring an understanding of this description. Phrases such as "an embodiment," "various embodiments," "some embodiments," and the like may include features, structures, or characteristics, but not every embodiment necessarily includes the particular features, structures, or characteristics.

Some embodiments may have some, all, or none of the features described for other embodiments. "First," "second," "third," and the like describe a common object and indicate different instances of like objects being referred to. Such adjectives do not imply objects so described must be in a given sequence, either temporally or spatially, in ranking, or any other manner.

Embodiments herein relate to hybrid complementary metal oxide semiconductor (CMOS) architectures with gate-all-around (GAA) field effect transistors (FETs) and the fabrication techniques thereof. CMOS architectures involve integrated circuits that combine both n-type metal oxide semiconductor (NMOS) transistors and p-type metal oxide semiconductor (PMOS) transistors on a single chip. The PMOS and NMOS transistors may be arranged in a complementary configuration to create logic gates and other circuit elements.

CMOS GAA FETs can be fabricated from discrete stacks of layered materials (e.g., two alternating layers in each stack) to produce devices comprising purely or predominately Si channels (e.g., n-type transistors or nFETs). For example, a SiGe/Si (silicon-germanium/silicon) stack can be used to make Si NMOS/Si PMOS nanoribbon transistors, where SiGe is the sacrificial layer and Si layers are used to form the channels for both NMOS and PMOS. Fabricating the channel regions can include removing (e.g., by etching) the sacrificial layer, such as SiGe, and releasing the Si layers for both NMOS and PMOS transistors.

In some scenarios, various additional techniques may be used to fabricate the channel regions of Si PMOS nanoribbon transistors. For example, a high-temperature diffusion process may be used to convert silicon channel regions to silicon-germanium (SiGe) for PMOS transistors. These high D*t nanoribbons may be formed for GAA FETs using a high-temperature, vacancy-mediated diffusion process before source/drain epitaxial (epi) regions are formed at opposite ends of the source/drain regions. A layer of material comprising additive elements may be deposited on and around nanoribbon channels, and atoms of the additive element(s) may be introduced into, and thoroughly interspersed in, the crystal lattice of the nanoribbon channel by vacancy-assisted diffusion. Oxygen (and/or nitrogen, etc.) vacancies may be introduced by a capping layer that encapsulates the nanoribbon channel and the layer comprising the additive element(s) and retains the vacancy element(s) during the diffusion process.

In a different additional technique that may be used to fabricate the channel regions of Si PMOS nanoribbon transistors, once GAA FET channels have been released (e.g., sacrificial layers have been removed) during the fabrication process, the channel lattice may be modified by the addition of a new element. For example, germanium atoms may be added to nanoribbons consisting of purely or predominantly silicon (without germanium) via a diffusion process described above. To avoid out-diffusion of dopants from the source/drain regions to the channel regions, the high temperature diffusion process may be performed before formation of the epi source/drain regions, allowing for uniform, high stress channels that are free from any dopants.

The fabrication techniques enable the use of one material (e.g., silicon) for the channels of different types of GAA FETs, which can be leveraged to produce CMOS integrated circuit devices. For example, utilizing the techniques described above for a chip with a CMOS architecture, silicon channels of the PMOS transistors may be diffused with additive elements (e.g., diffused with SiGe), while the silicon channels of the NMOS transistors remain as pure or predominantly silicon after the sacrificial layers are removed and the NMOS silicon channels are released. The channels of differing materials, with and without the added element(s), may be positioned as channels that are parallel and at identical heights in stacks with identical pitches.

NMOS and PMOS transistors work together to achieve complementary switching in CMOS devices. In some scenarios, it is desirable to have balanced performance to ensure similar speed and power efficiency. In other scenarios, a particular relative carrier mobility difference and/or threshold voltage may be desired.

Generally, NMOS and PMOS transistors have varying drive capacities. Consequently, NMOS transistors and PMOS transistors may provide different currents and/or different charges/discharges of capacitive loads. Typically, NMOS transistors have a higher drive capacity than PMOS transistors. For example, an NMOS transistor may conduct current more efficiently due to lower resistance. NMOS and PMOS transistors also typically have different carrier mobilities. The carrier mobility of an NMOS transistor (also known as "electron mobility") is usually higher than the carrier mobility of a PMOS transistor (also known as "hole mobility"). This can result in an NMOS transistor switching faster than a PMOS transistor. Thus, the NMOS transistor can more rapidly charge/discharge load capacitances than the PMOS transistor. Consequently, PMOS transistors may be wider than NMOS transistors to balance the drive strength.

Drive capacity (or drivability) can be adjusted to achieve a specific performance or power by using NMOS-PMOS (NP) ratio targeting. The NP ratio is the ratio of the physical widths or drive strengths of NMOS to PMOS transistors. The NP ratio may be expressed as *W_{N}* / W*_{P},* where W*_{N}* and W*_{P}* represent the widths of NMOS and PMOS transistors, respectively. In current nanoribbon architecture, however, the flexibility in NP ratio targeting is limited because the NMOS and PMOS transistors have the same stack height (e.g., an equal number of ribbons where the respective NMOS and CMOS ribbons are coplanar).

Embodiments disclosed herein can resolve these issues (and more). Embodiments herein relate to asymmetric NMOS and PMOS stack height in hybrid CMOS architecture and the fabrication techniques thereof. In particular, a stack for fabricating NMOS and PMOS transistors can be used to create GAA FET channels by releasing two different materials depending on whether the transistor is NMOS type of transistor or PMOS type of transistor. For example, gate-all-around (GAA) field effect transistors (FETs) can be fabricated from a SiGe/Si (silicon-germanium/silicon) stack to make SiGe PMOS/Si NMOS stacks with asymmetric stack height, where the stack height of one type of transistor is greater than or less than (but not equal to) the stack height of the other type of transistor. Thus, a typical SiGe/Si stack used to make Si NMOS and Si PMOS nanoribbon transistors can be used instead to make SiGe PMOS and Si NMOS transistors with asymmetric stack height. In some embodiments, the asymmetric stacks may include an equal number of channels (e.g., nanoribbons). In other embodiments, the asymmetric stacks may include an unequal number of channels, such that the number of channels of one type of transistor is greater than or less than the number of channels of the other type of transistor.

Embodiments disclosed herein provide several advantages. The asymmetric stack height, utilizing a first material for the channels of the NMOS transistors and a second material for the channels of the PMOS transistors, enables greater flexibility in NP ratio targeting. Thus, embodiments herein enable specific performance and/or power goals between the NMOS and PMOS transistors to be achieved. Additionally, the use of a particular layer (e.g., SiGe, Ge, germanium-tin, etc.) in a stack to be masked and released for PMOS transistors and a different layer (e.g., Si) in the stack to be masked and released may minimize the diffusion processes needed during the fabrication of the NMOS and PMOS transistors.

Reference is now made to the drawings, which are not necessarily drawn to scale, wherein similar or same numbers may be used to designate same or similar parts in different figures. The use of similar or same numbers in different figures does not mean all figures including similar or same numbers constitute a single or same embodiment. Like numerals having different letter suffixes may represent different instances of similar components. The drawings illustrate generally, by way of example, but not by way of limitation, various embodiments discussed in the present document.

In the following description, for purposes of explanation, numerous specific details are set forth to provide a thorough understanding thereof. It may be evident, however, that the novel embodiments can be practiced without these specific details. In other instances, well-known structures and devices are shown in block diagram form to facilitate a description thereof. The intention is to cover all modifications, equivalents, and alternatives within the scope of the claims.

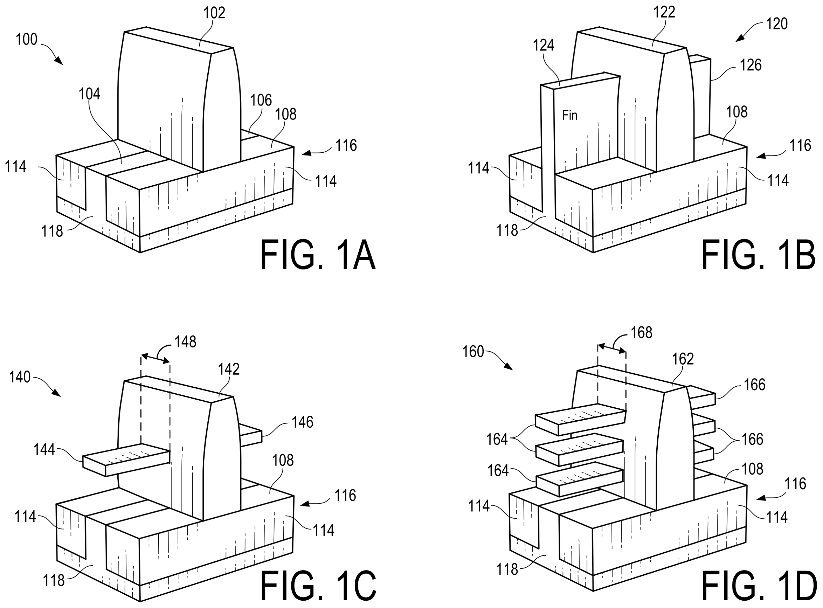

FIGS. 1A-1D are perspective views of example planar, FinFET, gate-all-around, and stacked gate-all-around transistors. The transistors illustrated in FIGS. 1A-1D are formed on a substrate 116 having a substrate surface 108 and a bulk region 118. Isolation regions 114 separate the source and drain regions (also referred to a "source/drain" regions) of the transistors from other transistors.

FIG. 1A is a perspective view of an example transistor 100 comprising a gate 102 that controls current flow between a source region 104 and a drain region 106. The transistor 100 is planar in that the source region 104, the drain region 106 and the substrate surface 108 lie in the same plane.

FIG. 1B is a perspective view of an example transistor 120 comprising a gate 122 that controls current flow between a source region 124 and a drain region 126. The transistor 120 is non-planar in that the source region 124 and the drain region 126 comprise "fins" that extend upwards from the substrate surface 108. The transistor 120 can be referred to as a FinFET. As the gate 122 encompasses three sides of the fin that extends from the source region 124 to the drain region 126, the transistor 120 can be considered a tri-gate transistor. FIG. 1B illustrates one S/D fin extending through the gate 122, but multiple S/D fins can extend through the gate of a FinFET transistor.

FIG. 1C is a perspective view of a transistor 140 comprising a gate 142 that controls current flow between a source region 144 and a drain region 146. The transistor 140 is non-planar in that the source region 144 and the drain region 146 lie in a different plane than the substrate surface 108. As the gate 142 encompasses all sides of the channel region of the transistor 140 that extends from the source region 144 at one end of the channel region to the drain region 146 at the opposite end of the channel region, the transistor 140 can be referred to as a gate-all-around (GAA) transistor.

FIG. 1D is a perspective view of a transistor 160 comprising a gate 162 that controls current flow between multiple elevated source regions 164 and multiple elevated drain regions 166. The transistor 160 is a stacked GAA transistor as the gate controls the flow of current between multiple elevated S/D regions stacked on top of each other. The transistors 140 and 160 are considered gate-all-around transistors as the gates encompass all sides of the channel regions of the transistor that extends from the source regions to the drain regions. The transistors 140 and 160 can alternatively be referred to as nanowire, nanosheet, or nanoribbon transistors depending on the width (e.g., widths 148 and 168 of transistors 140 and 160, respectively) of the channel regions extending through the gate.

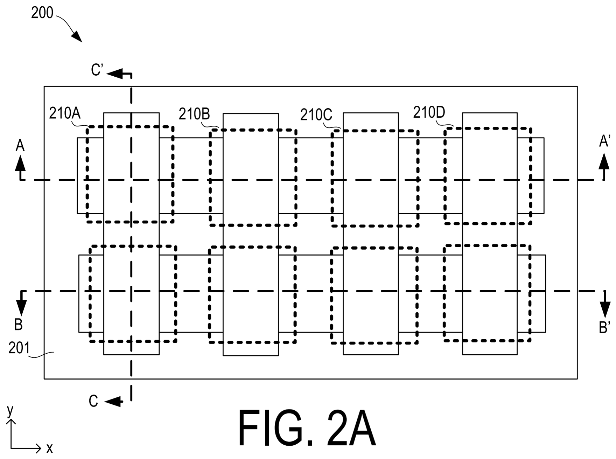

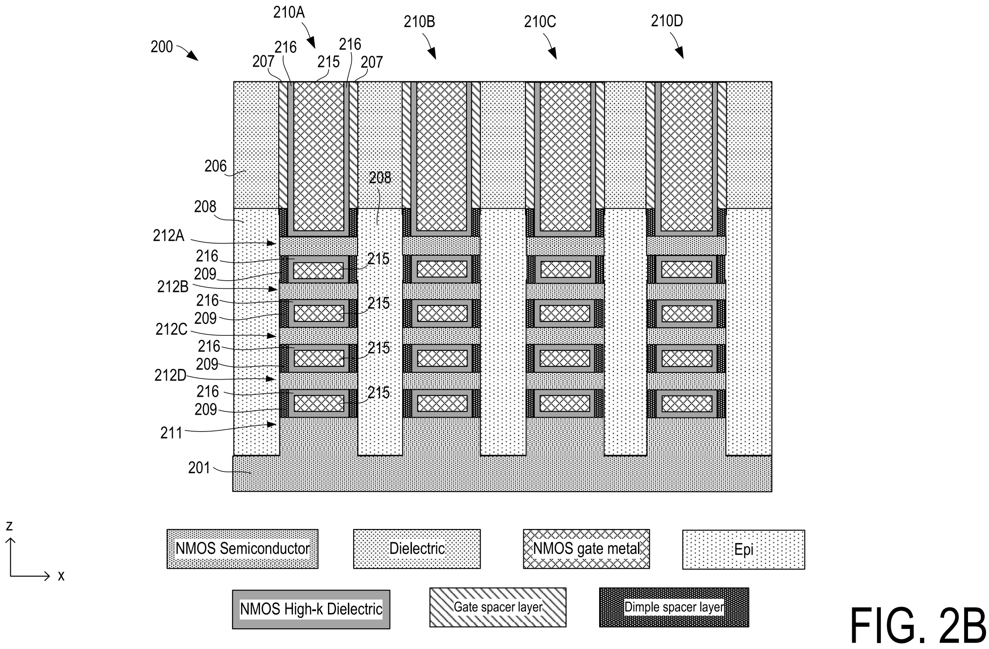

Turning to FIGS. 2A-2D, FIG. 2A illustrates a top plan view of an example integrated gate-all around (GAA) device assembly 200 for a hybrid complementary metal oxide semiconductor (CMOS) architecture. Some elements referred to in the description of FIGS. 2A-2D with reference numerals are illustrated in these figures with different patterns. A legend is included at the bottom of the page of FIG. 2A and 2B showing the patterns and a description.

The device assembly 200 includes a plurality of first GAA transistors 210 (individually referenced as 210A, 210B, 210C, and 210D) and a plurality of second GAA transistors 220 (individually referenced as 220A, 220B, 220C, and 220D). Each of the GAA transistors of the device assembly 200 are formed on a base layer 201, which may be embodied as a substrate. In the example shown, the base layer 201 is a semiconductor layer (e.g., one comprising one or more of silicon, germanium, indium antimonide, lead telluride, indium arsenide, indium phosphide, gallium arsenide, or gallium antimonide). As shown in FIGS. 2A-2D, the first GAA transistors 210 are n-type metal oxide semiconductor (NMOS) transistors and second GAA transistors 220 are p-type metal oxide semiconductor (PMOS) transistors.

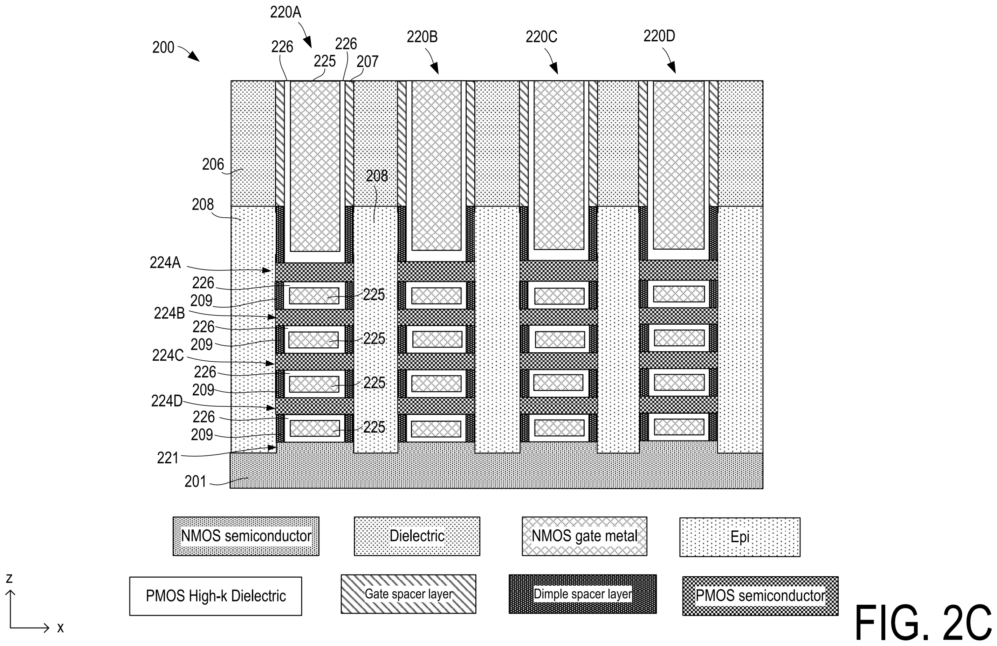

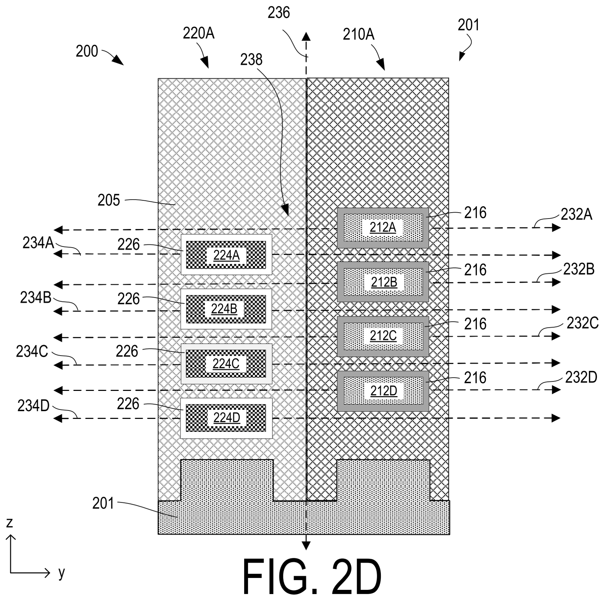

FIGS. 2B-2D illustrate cross-sectional views of the device assembly 200. FIG. 2B is a cross-sectional profile view taken along line A-A' of FIG. 2A, showing example NMOS channel regions 212 (individually referenced as 212A, 212B, 212C, and 212D) formed as stacks of nanoribbons in adjacent NMOS transistors according to an embodiment. FIG. 2C is a cross-sectional profile view taken along line B-B' of FIG. 2A, showing example PMOS channel regions 224 (individually referred to as 224A, 224B, 224C, and 224D channel regions or nanoribbons) formed as stacks of nanoribbons in adjacent PMOS transistors 220 on the base layer 201 according to an embodiment. FIG. 2D is a cross-sectional view taken along line C-C' of FIG. 2A, showing the example channel regions 212A-212D and 224A-224D of NMOS transistor 210A and PMOS transistor 220A, respectively, having asymmetric stack heights.

Although a certain number of nanoribbons are shown in FIGS. 2B-2D, any number of nanoribbons or other types of channels (e.g., nanowires, nanosheets, etc.) can be formed in NMOS and PMOS transistors of the various examples shown and described herein. Channels such as nanoribbons, nanowires, nanosheets, etc., may be referred to herein as "channel regions."

As shown in FIG. 2B, each NMOS transistor 210 includes four NMOS channel regions 212 (e.g., 212A, 212B, 212C, and 212D) that are formed above a sub-fin 211 that extends from the body of the base layer 201. The NMOS channel regions 212 are between (and adjacent to/in contact with) epitaxial regions 208 that may function as source/drain regions of the NMOS transistors 210. The epitaxial regions 208 are grown on the base layer 201 and may include a semiconductor material that is doped with dopants such as boron, arsenic, or phosphorous.

Each NMOS transistor 210 also includes a gate region 215 that surrounds each NMOS channel region 212 as shown, with a layer 216 of high-k dielectric material between the NMOS channel regions 212 and the gate region 215. Gate regions 215 may include any suitable conductive material, e.g., a metal. For NMOS transistors, gate regions 215 may include an n-type work function metal.

In the example shown, each NMOS transistors 210 also includes dimple spacer layers 209 adjacent to the high-k dielectric layers 216 and between various portions of the gate regions 215 and the epitaxial regions 208. Each NMOS transistor 210 may also include a gate spacer layer 207 between the high-k dielectric layer 216 in the NMOS transistor 210 and an upper layer 206. The gate spacer layers 207, dimple spacer layers, and upper layers 206 can include an insulating or non-conducting (e.g., dielectric) material.

As shown in FIG. 2C, each PMOS transistor 220 includes four PMOS channel regions 224 (e.g., 224A, 224B, 224C, and 224D) that are formed above a sub-fin 221 that extends from the body of the base layer 201. The PMOS channel regions 224 are between (and adjacent to/in contact with) epitaxial regions 208 that may function as source/drain regions of the PMOS transistors 220. The epitaxial regions 208 are grown on the base layer 201, and may include a semiconductor material that is doped with dopants such as boron, arsenic, or phosphorous. In other examples, the upper layer 206 and/or epitaxial regions 208 of the PMOS transistors 220 may be made from dielectric materials (e.g., insulating or non-conducting) that are different than the upper layer 206 and/or epitaxial regions 208 of the NMOS transistors 210.

Each PMOS transistor 220 also includes a gate region 225 that surrounds each PMOS channel region 224 as shown, with a layer 226 of high-k dielectric material between the PMOS channel regions 224 and the gate region 225. Gate region 225 may include any suitable conductive material, e.g., a metal. For PMOS transistors, gate region 225 may include p-type work function metal.

In the example shown, each PMOS transistor 220 also includes a dimple spacer layer 209 adjacent to the high-k dielectric layer 226 and between various portions of the gate region 225 and the epitaxial regions 208. Each PMOS transistor 220 may also include a gate spacer layer 207 between the high-k dielectric layer 226 in the PMOS transistor 220 and the upper layer 206. The gate spacer layers 207, dimple spacer layers 209, and upper layers 206 can include insulating or non-conducting (e.g., dielectric) materials.

It should be noted that the high-k dielectric layers 216 used in the NMOS transistors 210 and the high-k dielectric layer 226 used in the PMOS transistors 220 may be different, or in some designs, may be the same. The high-k dielectric layers 216 may be any suitable dielectric used in an NMOS transistor with the semiconducting material of the NMOS channel regions 212 and the particular gate stack of the NMOS transistors 210 on the base layer 201. The high-k dielectric layer 226 may be any suitable dielectric used in a PMOS transistor with the semiconducting material of the PMOS channel regions 224 and the particular gate stack of the PMOS transistors 220 on the base layer 201.

Nonlimiting examples of suitable high-k dielectric materials include, but are not necessarily limited to, hafnium oxide, zirconium oxide, aluminum oxide, lanthanum oxide, yttrium oxide, tantalum pentoxide, silicon dioxide, or any suitable stack combination thereof. In some scenarios, low-k dielectric materials may be used. Examples of elements that may be used as a dielectric and/or in combination with one or more other elements to form a dielectric include hafnium, silicon, oxygen, nitrogen, titanium, tantalum, lanthanum, aluminum, zirconium, barium, strontium, yttrium, lead, scandium, niobium, and zinc. More specific examples of other possible dielectric materials that may be used in one or more embodiments herein include, but are not limited to, silicon nitride, silicon oxide, silicon carbide, silicon nitride doped with carbon, silicon oxynitride, hafnium silicon oxide, lanthanum aluminum oxide, zirconium silicon oxide, tantalum oxide, titanium oxide, barium strontium titanium oxide, barium titanium oxide, strontium titanium oxide, tantalum silicon oxide, lead scandium tantalum oxide, and lead zinc niobate.

As shown in FIGS. 2B-2D, the material of gate regions 215 in the NMOS transistors 210 may be different than the material of gate regions 225 in the PMOS transistors 220. In other scenarios, the same material may be used with appropriate doping agents. In some nonlimiting examples, the gate regions 215 of NMOS transistors 210 may be made from titanium nitride (TiN), tantalum nitride (Ta), titanium aluminum (TiAl), or tungsten nitride (WN), and the gate regions 225 of PMOS transistors 220 may be made from platinum (Pt), nitride (N), TaN, or TiN with appropriate doping agents.

In some examples, NMOS channel regions 212 form a stack of layers including any suitable semiconducting material (e.g., pure (or predominantly) silicon, pure (or predominantly) germanium, etc.), while the PMOS channel regions 224 form a stack of layers including a different semiconducting material (e.g., germanium, silicon-germanium, germanium-tin, etc.). Because the NMOS transistors 210 and PMOS transistors 220 are made on the same substrate, their layers may be etched from the same superlattice stack of alternating layers of a first semiconducting material (e.g., silicon) for the NMOS transistors 210 and a second semiconducting material (e.g., silicon-germanium) for the PMOS transistors 220. Thus, the stacks of the NMOS channel regions 212 and the PMOS channel regions 224 are asymmetric and the height of each stack relative to the base layer 201 can be different.

As shown in FIG. 2D, as measured from the base layer 201, the stack height of NMOS transistor 210A is higher than the stack height of PMOS transistor 220A, although each stack includes an equal number of channel regions (i.e., four) in this example. Using a superlattice stack, the channel regions 212 of the NMOS transistors 210 can be formed by removing (e.g., etching out) a second semiconducting material (e.g., germanium), and the channel regions 224 of the PMOS transistors 220 can be formed by removing (e.g., etching out) the first semiconducting material (e.g., silicon). Consequently, the channel regions 212 of the NMOS transistors 210 are not coplanar with the channel regions 224 of the PMOS transistors.

As illustrated in FIG. 2D, horizontal planes coinciding with the NMOS channel regions 212 are represented by lines 232 (individually referenced as 232A, 232B, 232C, and 232D). Horizontal planes coinciding with the PMOS channel regions 224 are represented by lines 234 (individually referenced as 234A, 234B, 234C, and 234D). A vertical axis 236 is defined between the PMOS transistor 220 and the NMOS transistor 210. Each of the horizontal planes coinciding with the NMOS channel regions 212 are substantially parallel to (and axially spaced from) the base layer 201 (or substrate) and each of the horizontal planes coinciding with the PMOS channel regions 224. Consequently, the NMOS channel regions 212 and the PMOS channel regions are not coplanar but instead lie in different planes that are at least substantially parallel and axially spaced apart relative to the vertical axis 236. This spacing results in the NMOS channel regions 212 and the PMOS channel regions 224 being asymmetrically aligned on opposite sides of a space 238 defined therebetween. In some embodiments, the space 238 may be filled with one or more gate materials (e.g., metals), and/or any other suitable materials for insulating (e.g., isolation structures such as oxide or dielectric layers) or conductive activities based on particular needs and/or design of the CMOS architecture.

Although FIGS. 2A-2D illustrate four NMOS transistors and four PMOS transistors, it should be noted that any number of NMOS and PMOS transistors may be formed on a substrate according to this disclosure. Furthermore, each row of transistors (e.g., row of NMOS transistors 210, row of PMOS transistors 220) may include a single type of transistor (e.g., NMOS or PMOS) as shown in FIGS. 2A-2D, or may include a combination of NMOS and PMOS transistors. For example, in other embodiments, each row may include alternating NMOS and PMOS transistors, an equal number of NMOS and PMOS transistors in any pattern, or an unequal number of NMOS and PMOS transistors in any pattern.

As used herein, the term "region" may refer to a volume of an apparatus, device, or other object. Thus, a conductive region may refer to a volume of conducive material, and a dielectric region may refer to a volume of dielectric material. Further, as used herein, the term "surrounds" may refer to a first material (or region of a material) encompassing all sides of another, second material in at least one cross-sectional dimension, and may include one or more intermediate materials between the first and second materials. For example, as described above, the visible gate region 205 and the high-k dielectric layers 216 surround each channel region 212A-212D of NMOS transistor 210A in the cross-section of FIG. 2D, but do not surround the channel regions 212A-212D of NMOS transistor 210A in the cross-section shown in FIG. 2B. Similarly, the visible gate region 205 and the high-k dielectric layers 226 surround each channel region 224A-224D of PMOS transistor 220A in the cross-section of FIG. 2D, but do not surround the channel regions 224A-224D of PMOS transistor 220A in the cross-section shown in FIG. 2C.

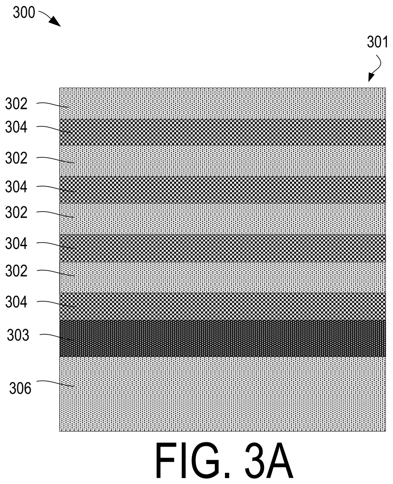

FIGS. 3A-3E illustrate an example process 300 for forming a device assembly 350 including adjacent NMOS and PMOS GAA FETs for a hybrid CMOS architecture in accordance with the present disclosure. The legends illustrated at the bottom of the pages of FIGS. 2B-2C, which show different patterns used to indicate different elements in the figures, are also applicable to FIGS. 3A-3E.

In process 300, the device assembly includes an NMOS transistor having a stack of four channel regions (e.g., nanoribbons) and a PMOS transistor having a stack of four channel regions, where the NMOS channel regions and the PMOS channel regions are asymmetrically aligned on opposite sides of a space defined between the NMOS channel regions and the PMOS channel regions such that the stack height of the NMOS channel regions is different than the stack height of the PMOS channel regions relative to the base layer (or substrate of the device assembly).

The example process 300 may include additional, fewer, or other operations than those shown. Additionally, the operations of process 300 can be performed in another order than shown. Furthermore, some of the operations shown or described as being separate may be performed simultaneously, while some of the operations shown or described as being performed at the same time may be performed at different times. Although a certain number of channel regions in the form of nanoribbons are shown in the transistors, any number of channel regions or other types of transistor channels can be formed using the process 300.

Referring first to FIG. 3A, the process 300 begins with a superlattice stack 301 of material that includes first layers 302, second layers 304, an optional third layer 303, and a base layer 306. Process 300 illustrates the formation of one NMOS GAA transistor and one PMOS GAA transistor in the superlattice stack 301. As previously described herein, however, the number of NMOS and PMOS transistors in a particular device may vary and any number of NMOS transistors and PMOS transistors may be formed, in any suitable pattern in a stack, based on the needs and design of the particular CMOS device being made.

In some examples, first layers 302 may be composed of a first crystalline (e.g., semiconducting) material suitable for forming an n-type metal oxide semiconductor (NMOS) GAA transistor, and second layers 304 may be composed of a second crystalline material suitable for forming a p-type metal oxide semiconductor (PMOS) GAA transistor. Optionally, the third layer 303 (e.g., silicon-germanium (SiGe)) may be provided above the base layer 306 of the superlattice stack to provide a thick buffer layer to relax the strain in the overlying layers to reduce defects and/or enable epitaxial growth. The base layer 306 may be a substrate (e.g., a semiconductor layer) or a layer transfer to allow the transfer of the stack to another substrate. The base layer 306 may be made of the same material as the first layers (e.g., silicon or any other suitable material).

In some embodiments, the materials in first and second layers 302 and 304 share one or more constituent elements. Any suitable semiconducting materials (e.g., pure or predominantly silicon, germanium, etc.) may be employed, or materials that may be semiconductors with the addition of one or more elements diffused into the crystalline lattice. Although various specific material examples are provided herein, the nanoribbons may include, or may be enhanced to include, two or more materials from group IV materials, group III-V materials, group II-VI materials, and/or any other suitable semiconducting materials based on the particular needs and design of the hybrid CMOS architecture in which NMOS and PMOS transistors are to be formed.

Some nonlimiting examples of layers 302 and 304 include respectively, silicon (e.g., first layers 302) and germanium (e.g., second layers 304), silicon (e.g., first layers 302) and silicon-germanium (e.g., second layers 304), or germanium (e.g., first layers 302) and germanium-tin (e.g., second layers 304). In silicon and silicon-germanium stacks, for example, the silicon-germanium (SiGe) stack is used for a PMOS transistor, and the pure (or predominantly) silicon stack is used for an NMOS transistor. For ease of illustration, the description of process 300 may reference the first layers 302 and the base layer 306 as comprising silicon, the second layers 304 as comprising germanium, and the third layer 303 as comprising silicon-germanium.

In one nonlimiting example, the first layers 302 may have a thickness measured as eight nanometers and be tensilely strained, and the second layers may have a thickness measured as eight nanometers and be compressively strained. In other examples, the first and second layers may each have a thickness in the range of 2-500 nanometers. Furthermore, the thickness of the first layers 302 (for NMOS transistors) as compared to the second layers 304 (for PMOS transistors) may be the same or may vary depending on the particular needs and/or configuration (including materials used in the superlattice stack) of the NMOS and PMOS transistors in the hybrid CMOS architecture. It should be noted that the base layer 306 may be thicker than at least the other first layers 302 that include the first semiconducting material, as the base layer may function as a layer transfer or a substrate.

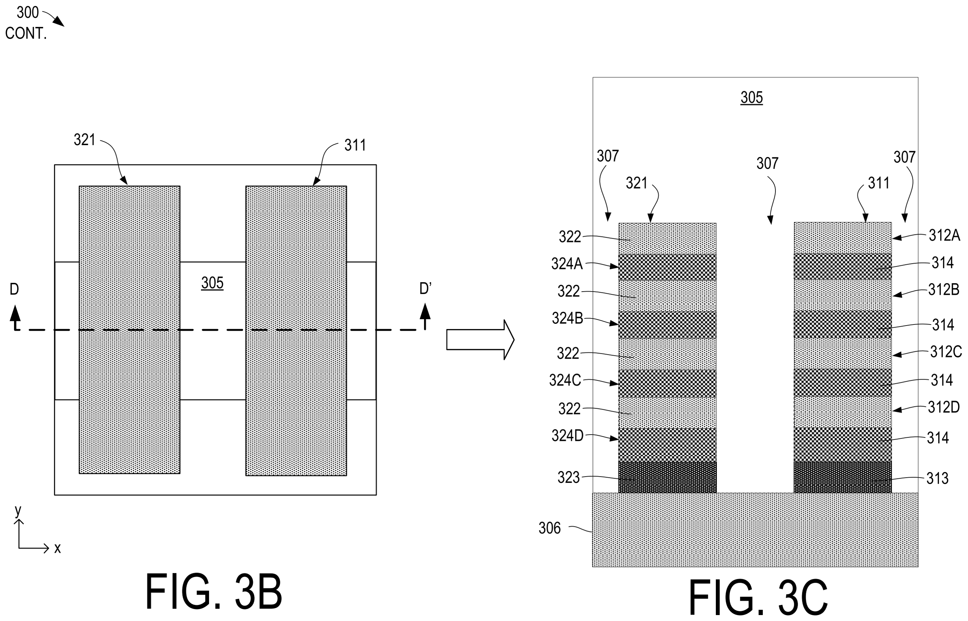

The process 300 can begin as shown in FIGS. 3B and 3C. FIG. 3B shows a simplified top view of the superlattice stack 301 after the first and second layers 302 and 304 have been etched to form a first discrete stack 311 and a second discrete stack 321 to enable the formation of an NMOS transistor and a PMOS transistor, respectively. A gate replacement region 305 indicates where a gate stack may be formed once the sacrificial layers are removed and the appropriate insulating and/or non-conducting materials are applied. In some examples, gate spacer layers (e.g., not visible in the views of FIGS. 3A-3B, but illustrated in FIGS. 2B-2C as gate spacer layers 207) that include insulating or non-conducting material (e.g., dielectric material) may be formed adjacent to the gate replacement regions 305.

FIG. 3C is a cross-section of the etched stack of FIG. 3B, taken along the cross-section line D-D' shown in FIG. 3B. The etching of regions 307 in the superlattice stack 301 forms the first discrete stack 311 including four channel regions 312 (individually referenced as 312A, 312B, 312C, and 312D). The four channel regions 312 are formed from portions of the first layers 302 remaining in the first discrete stack 311 after the etching. The four channel regions 312 in the first discrete stack 31 alternate with the portions 314 of the second layers 304 remaining in the first discrete stack 311 after the etching. The remaining portions 314 in the first discrete stack 311 are the sacrificial layers to be removed by additional etching. If a buffer layer (e.g., third layer 303) is present in the original superlattice stack 301, the first discrete stack 311 may also include a portion 313 of the buffer layer (e.g., third layer 303) that has not been etched out of the first discrete stack 311.

The etching of regions 307 in the superlattice stack 301 also forms the second discrete stack 321 including four channel regions 324 (individually referenced as 324A, 324B, 324C, and 324D). The four channel regions 324 are formed from portions of the second layers 304 remaining in the second discrete stack 321 after the etching. The four channel regions 324 in the second discrete stack 321 alternate with portions 322 of the first layers 302 remaining in the second discrete stack 321 after the etching. The remaining first layer portions 322 in the second discrete stack 321 are the sacrificial layers to be removed by additional etching. If a buffer layer (e.g., third layer 303) is present in the original superlattice stack 301, the second discrete stack 321 may include a portion 323 of the buffer layer (e.g., third layer 303) that has not been etched out of the second discrete stack 321.

Although not visible in FIGS. 3A-3B, in some examples, the remaining second layer portions 314 in the first discrete stack 311 and the remaining first layer portions 322 in the second discrete stack 321 may have edge portions that are also etched away when forming the first discrete stacks 311 and 321. Dimple spacer layers (shown in FIGS. 2B-2C as dimple spacer layers 209) can include an insulating or non-conducting material (e.g., dielectric) and may be formed in these etched away edge portions of the remaining second layer portions 314 and the remaining first layer portions 322.

Additionally, additional layers not visible in FIGS. 3A-3B, may be formed on the device assembly. For example, epitaxial regions (e.g., shown in FIGS. 2A-2B as epitaxial regions 208) can be grown on the substrate or the base layer 306 (e.g., silicon) on the sides of the discrete stacks 311 and 321. For example, epitaxial regions may be grown at opposite ends of the channel regions 312 in the first discrete stack 311 and at opposite ends of the channel regions 324 in the second discrete stack 321. Another layer of insulating or non-conducting material (e.g., shown in FIGS. 2A-2B as upper layer 206) can be formed above the epitaxial regions. The upper layer 206 may include a dielectric material, for example. Example epitaxial regions are shown in FIGS. 2A-2B as epitaxial regions 208, and the layer formed above the epitaxial regions is shown in FIGS. 2A-2B as upper layer 206.

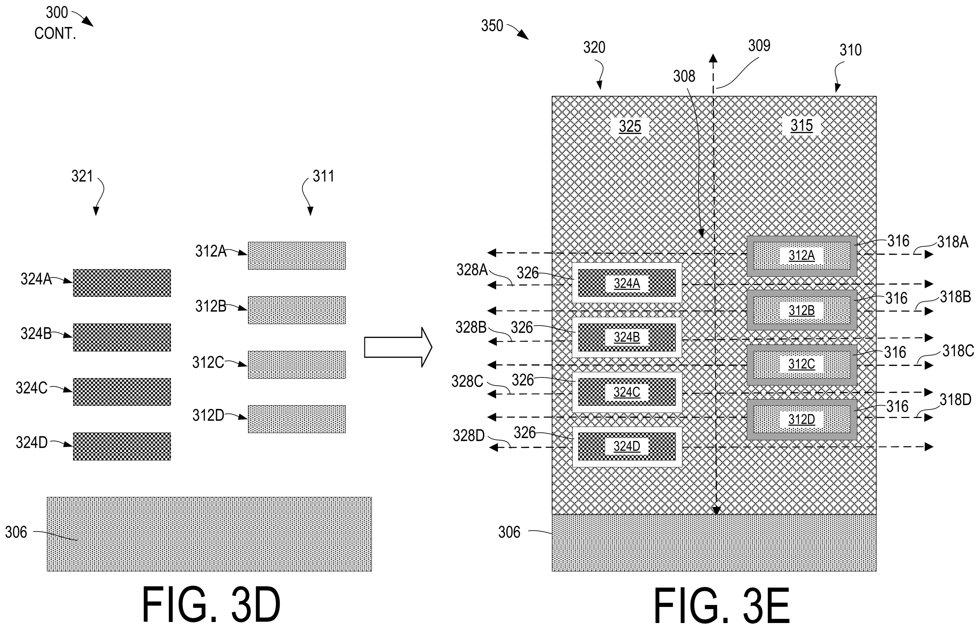

As shown in FIG. 3D, the sacrificial material layers (e.g., remaining first layer portions 322) may be removed from the second discrete stack 321 and the sacrificial material layers (e.g., remaining second layer portions 314) may be removed from the first discrete stack 311. The removal process is known as a nanoribbon release. In this example, two different nanoribbon materials are released. The channel regions 312 (e.g., silicon) of the first discrete stack 311 are released to form the NMOS transistor 310, and the channel regions 324 (e.g., germanium) of the second discrete stack 321 are released for use in the PMOS transistor 320. Thus, two different materials are released and the particular material to be released for a given transistor is based on the type (e.g., NMOS or PMOS) of that transistor.

After the sacrificial layers are removed, the channel regions 312 and 324 are left floating, but are supported at each end and held in their respective positions by the epitaxial regions formed at opposite ends of the channel regions 312 and 324. A dielectric layer such as an upper layer located on the epitaxial regions may also help support the floating channel regions.

Known nanoribbon release processes may be used, leaving the released nanoribbons (e.g., channel regions 312 in the first discrete stack 311 and channel regions 324 in the second discrete stack 321). In one example, the sacrificial material layers (e.g., remaining first layer portions 322 and remaining second layer portions 314) may be removed using an etching process, such as dry etch, wet etch, or any suitable combination thereof. An etchant material used to remove the remaining first layer portions 322 is selective to the adjacent channel material such that the etchant material removes the remaining first layer portions 322 but does not remove the material of the channel regions 324. Similarly, an etchant material used to remove the remaining second layer portion 314 is selective to the adjacent channel material such that the etchant material removes the remaining second layer portions 314 but does not remove the material of the channel regions 312.

It should be noted that, when the first discrete stack 311 is etched to remove the sacrificial layers (e.g., remaining second layer portions 314 such as germanium), a mask may be applied to discrete stack 321. This can protect the discrete stack 321 as different etchant materials may be used, and different portions of the stacks will be removed. Similarly, when discrete stack 321 is etched to remove the sacrificial layers (e.g., remaining first layer portions 322 such as silicon), a mask may be applied to the first discrete stack 311.

Then, as shown in FIG. 3E, the masks can be removed, and a first high-k dielectric layer 316 can be formed in at least a portion of the voided regions of the first discrete stack 311 to surround each of the channel regions 312 in the first discrete stack 311. A second high-k dielectric layer 326 can be formed in at least a portion of the voided regions of the second discrete stack 321 around each of the channel regions 324 in the second discrete stack 321.

This can be followed by formation of a gate metal/conductor 315/325 as shown to form an NMOS transistor 310 and a PMOS transistor 320. It should be noted that in some cases, different gate materials may be used for an NMOS transistor and a PMOS transistor, with appropriate intermediate materials formed in a portion of the space 308 defined between the transistors. In other scenarios, the same gate material may be used.

With reference to the NMOS transistor 310 and PMOS transistor 320 in FIG. 3E, the stack height of the NMOS transistor 310 is different (e.g., higher relative to the substrate or base layer 306) than the stack height of the PMOS transistor 320. Horizontal planes coinciding with the NMOS channel regions 312 are represented by lines 318 (individually referenced as 318A, 318B, 318C, and 318D). Horizontal planes coinciding with the PMOS channel regions 324 are represented by lines 328 (individually referenced as 328A, 328B, 328C, and 328D). A vertical axis 309 is defined between the PMOS transistor 320 and the NMOS transistor 310. Each of the horizontal planes coinciding with the NMOS channel regions 312 are axially spaced from (and substantially parallel to) the base layer 306 (or substrate) and each of the horizontal planes coinciding with the PMOS channel regions 324. Consequently, the NMOS channel regions 312 and the PMOS channel regions are not coplanar but instead lie in different planes that are at least substantially parallel and axially spaced apart relative to the vertical axis 309. This spacing results in the NMOS channel regions 312 and the PMOS channel regions 324 being asymmetrically aligned on opposite sides of a space 308 defined therebetween.

In this example, the NMOS transistor 310 and the PMOS transistor 320 have an equal number (e.g., four) of channel regions. In some scenarios, however the number of channel regions may vary between NMOS transistors and PMOS transistors. Embodiments herein allow modification to the stack heights to adjust the performance of NMOS transistors and/or PMOS transistors to be more balanced, as will be further described below.

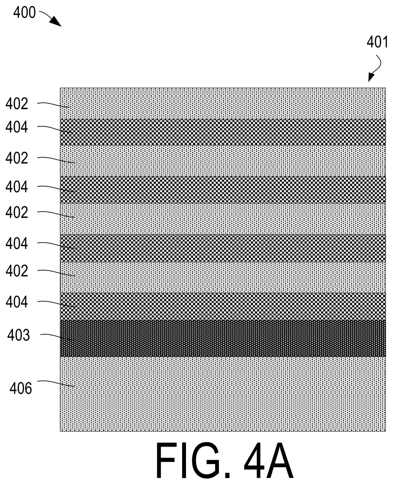

FIGS. 4A-4E illustrate another example process 400 for forming a device assembly 450 including NMOS and PMOS GAA FETs for a hybrid CMOS architecture in accordance with the present disclosure. The legends illustrated at the bottom of the pages of FIGS. 2A-2B, which show different patterns used to indicate different elements in the figures, are also applicable to FIGS. 4A-4E.

In process 400, the device assembly includes an NMOS transistor having a stack of three channel regions (e.g., nanoribbons) and a PMOS transistor having a stack of four channel regions, where the NMOS channel regions and the PMOS channel regions are asymmetrically aligned on opposite sides of a space defined between the NMOS channel regions and the PMOS channel regions.

The example process 400 may include additional, fewer, or other operations than those shown. Additionally, the operations of process 400 can be performed in another order than shown. Furthermore, some of the operations shown or described as being separate may be performed simultaneously, while some of the operations shown or described as being performed at the same time may be performed at different times. Although a certain number of channel regions in the form of nanoribbons are shown in the transistors, any number of channel regions or other types of transistor channels can be formed using the process 400.

Referring first to FIG. 4A, the process 400 begins with a superlattice stack 401. Process 400 illustrates the formation of one NMOS GAA transistor adjacent to one PMOS GAA transistor in the superlattice stack 401. As previously described herein, however, the number of NMOS and PMOS transistors in a particular device may vary and any number of NMOS transistors and PMOS transistors may be formed, in any suitable pattern in a stack, based on the needs and design of the particular CMOS device being made.

The superlattice stack may be the same or similar to the superlattice stacks previously described herein (e.g., superlattice stack 301 of FIG. 3A). For example, the superlattice stack 401 includes first layers 402, second stack layers, an optional third layer 403, and a base layer 406, which may be the same or similar to first layers 302, second layers 304, third layer 303, and base layer 306 of FIG. 3A. For ease of illustration, the description of process 400 may reference the first layers 402 and the base layer 406 as comprising silicon, the second layers 404 as comprising germanium, and the third layer 403 as comprising silicon-germanium.

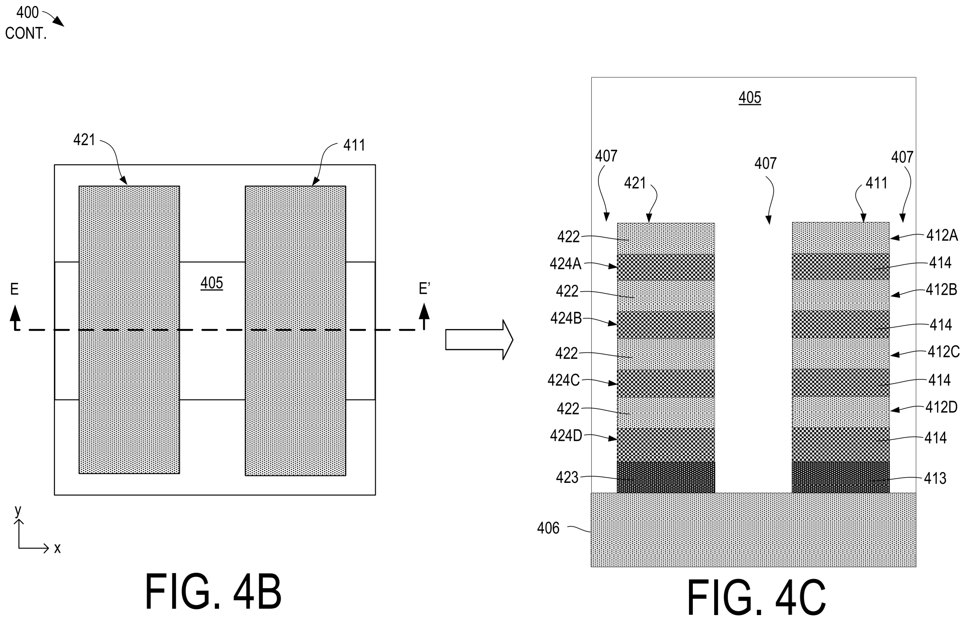

The process 400 can begin as shown in FIGS. 4B and 4C. FIG. 4B shows a simplified top view of the superlattice stack 401 after the first and second layers 402 and 404 have been etched to form a first discrete stack 411 and a second discrete stacks 421 to enable the formation of an NMOS transistor and a PMOS transistor, respectively. A gate replacement region 405 indicates where a gate stack may be formed once the sacrificial layers are removed and the appropriate insulating and/or non-conducting materials are applied. In some examples, gate spacer layers (e.g., not visible in the views of FIGS. 4A-4B, but illustrated in FIGS. 2B-2C as gate spacer layers 207) that include insulating or non-conducting material (e.g., dielectric material) may be formed adjacent to the gate replacement regions 405.

FIG. 4C is a cross-section of the etched stack of FIG. 4B, taken along the cross-section line E-E' shown in FIG. 4B. The etching of regions 407 in the superlattice stack 401 forms the first discrete stack 411 including four channel regions 412 (individually referenced as 412A, 412B, 412C, and 412D). The four channel regions 412 are formed from portions of the first layers 402 remaining in the first discrete stack 411 after the etching. The four channel regions 412 in the first discrete stack 411 alternate with the portions 414 of the second layers 404 remaining in the first discrete stack 411 after the etching. The remaining portions 414 in the first discrete stack 411 are the sacrificial layers to be removed by additional etching. If a buffer layer (e.g., third layer 403) is present in the original superlattice stack 401, the first discrete stack 411 may also include a portion 413 of the buffer layer (e.g., third layer 403) that has not been etched out of the first discrete stack 411.

The etching of regions 407 in the superlattice stack 401 also forms the second discrete stack 421 including four channel regions 424 (individually referenced as 424A, 424B, 424C, and 424D). The four channel regions 424 are formed from portions of the second layers 404 remaining in the second discrete stack 421 after the etching. The four channel regions 424 in the second discrete stack 421 alternate with portions 422 of the first layers 402 remaining in the second discrete stack 421 after the etching. The remaining portions 414 in the second discrete stack 421 are the sacrificial layers to be removed by additional etching. If a buffer layer (e.g., third layer 403) is present in the original superlattice stack 401, the second discrete stack 421 may include a portion 423 of the buffer layer (e.g., third layer 403) that has not been etched out of the second discrete stack 421.

Although not visible in FIGS. 4A-4B, in some examples, gate spacer layers (e.g., shown in in FIGS. 2B-2C as gate spacer layers 207), dimple spacer layers (e.g., shown in FIGS. 2B-2C as dimple spacer layers 209), epitaxial regions (e.g., shown in FIGS. 2A-2B as epitaxial regions 208), and a dielectric layer (e.g., shown in FIGS. 2A-2B as upper layer 206), may also be formed on the device assembly during process 400 in the same or similar manner as described with reference to FIGS. 2A-2D and 3A-3E.

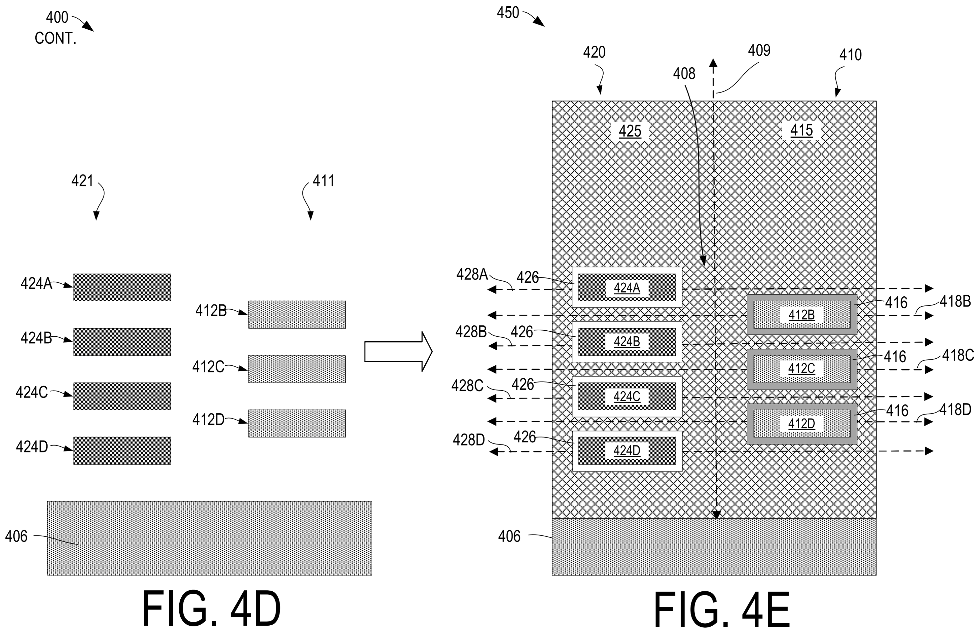

As shown in FIG. 4D, the sacrificial material layers (e.g., remaining first layer portions 422) may be removed from the second discrete stack 421, and the sacrificial material layers (e.g., remaining second layer portions 414) may be removed from the first discrete stack 411. A nanoribbon release process may be used to remove the sacrificial layers as previously described herein (e.g., FIG. 3D). In addition, process 400 allows for selective etching of channel regions from the discrete stacks to achieve a desired performance (e.g., drive capacity or drivability) of the resulting NMOS transistor and/or PMOS transistor. For example, if a resulting NMOS transistor with four channel regions 412A-412D would have more drive capacity than a resulting PMOS transistor with four channel regions 424A-424D, then one or more channel regions 412A, 412B, 412C, and/or 412D of the first discrete stack 411 may be removed in addition to removing the sacrificial layers (e.g., remaining second layer portions 414).

In the example process 400, further etching is performed on the first discrete stack 411 to remove a single channel region 412A. Accordingly, the channel regions 412B, 412C, and 412D (e.g., silicon) of the first discrete stack 411 are released to form an NMOS transistor 410, and all channel regions 424A, 424B, 424C, and 424D (e.g., germanium) of the second discrete stack 421 are released to form a PMOS transistor 420. Thus, two different materials are released and the particular material to be released for a given transistor is based on the type (e.g., NMOS OR PMOS) of that transistor.

After the sacrificial material layers are removed from the first and second discrete stacks 411 and 421 and the additional channel region 412A is removed from the first discrete stack 411, the channel regions 412B, 412C, and 412D of the first discrete stack 411 and the channel regions 424A, 424B, 424C, and 424D of the second discrete stack 421 are left floating, but are supported at each end and held in their respective positions by the epitaxial regions formed at opposite ends of the channel regions 412 and 424. A dielectric layer such as a dielectric upper layer located on the epitaxial regions may also help support the floating channel regions.

Similar to process 300, when the first discrete stack 421 is etched to remove the sacrificial layers (e.g., remaining second layer portions 414 such as germanium) and the channel region 412A (e.g., silicon), a mask may be applied to discrete stack 421. This can protect the discrete stack 421 as different etchant materials may be used, and different portions of the stacks will be removed. Similarly, when discrete stack 421 is etched to remove the sacrificial layers (e.g., remaining first layer portions 422 such as silicon), a mask may be applied to the first discrete stack 411.

Then, as shown in FIG. 4E, the masks can be removed, and a first high-k dielectric layer 416 can be formed in at least a portion of the voided regions of the first discrete stack 411 to surround each of the remaining channel regions 412B, 412C, and 412D in the first discrete stack 411. Second high-k dielectric layers 426 can be formed in at least a portion of the voided regions of the second discrete stack 421 around each of the channel regions 424A, 424B, 424C, and 424D.

This can be followed by formation of a gate metal/conductor 415/425 as shown to form an NMOS transistor 410 and a PMOS transistor 420. It should be noted that in some cases, different gate materials may be used for an NMOS transistor and a PMOS transistor, with appropriate intermediate materials formed in a portion of the space 408 defined between the transistors. In other scenarios, the same gate material may be used.

With reference to the NMOS transistor 410 and PMOS transistor 420 in FIG. 4E, the stack height of the NMOS transistor 410 is different than the stack height of the PMOS transistor 420. In this specific example, the stack height of the NMOS transistor 410 is less than than the stack height of the PMOS transistor relative to the substrate or base layer 406. The different number of channel regions in the NMOS transistor 410 is less than the number of channel regions in the PMOS transistor 420, which can help balance the performance of transistors. For example, fewer channel regions in the NMOS transistor 410 can reduce the drivability of the NMOS transistor 410 to more closely match the drivability of the PMOS transistor 420.

The channel regions 412B, 412C, and 412D of the NMOS transistor 410 are not coplanar with the channel regions 424A, 424B, 424C, and 424D of the PMOS transistors. Horizontal planes coinciding with the NMOS channel regions 412 are represented by lines 418 (individually referenced as 418A, 418B, 418C, and 418D). Horizontal planes coinciding with the PMOS channel regions 424 are represented by lines 428 (individually referenced as 428A, 428B, 428C, and 428D). A vertical axis 409 is defined between the PMOS transistor 420 and the NMOS transistor 410. Each of the horizontal planes coinciding with the NMOS channel regions 412 are substantially parallel to (and axially spaced from) the base layer 406 (or substrate) and each of the horizontal planes coinciding with the PMOS channel regions 424. Consequently, the NMOS channel regions 412 and the PMOS channel regions are not coplanar but instead lie in different planes that are at least substantially parallel and axially spaced apart relative to the vertical axis 409. This spacing results in the NMOS channel regions 412 and the PMOS channel regions 424 being asymmetrically aligned on opposite sides of a space 408 defined therebetween.

In this example, the NMOS transistor 410 has three channel regions and the PMOS transistor 420 has four channel regions. It should be apparent, however, that each transistor may be formed with any number of channel regions by simply removing the selected number of channel regions by etching (e.g., during the nanoribbon release process). For example, depending in part on the number of layers in the original superlattice stack 401, the NMOS transistor 410 may be formed with one, two, three, four or more channel regions and the PMOS transistor may be formed with one, two, three, four, or more channel regions. Furthermore, if multiple NMOS transistors and/or multiple PMOS transistors are formed from a superlattice stack, the NMOS transistors could potentially have an unequal number of channel regions (e.g., two NMOS transistors having four channel regions and two NMOS transistors having three channel regions) and/or the PMOS transistors could potentially have an unequal number of channel regions (e.g., two PMOS transistors having four channel regions and two PMOS transistors having five channel regions).

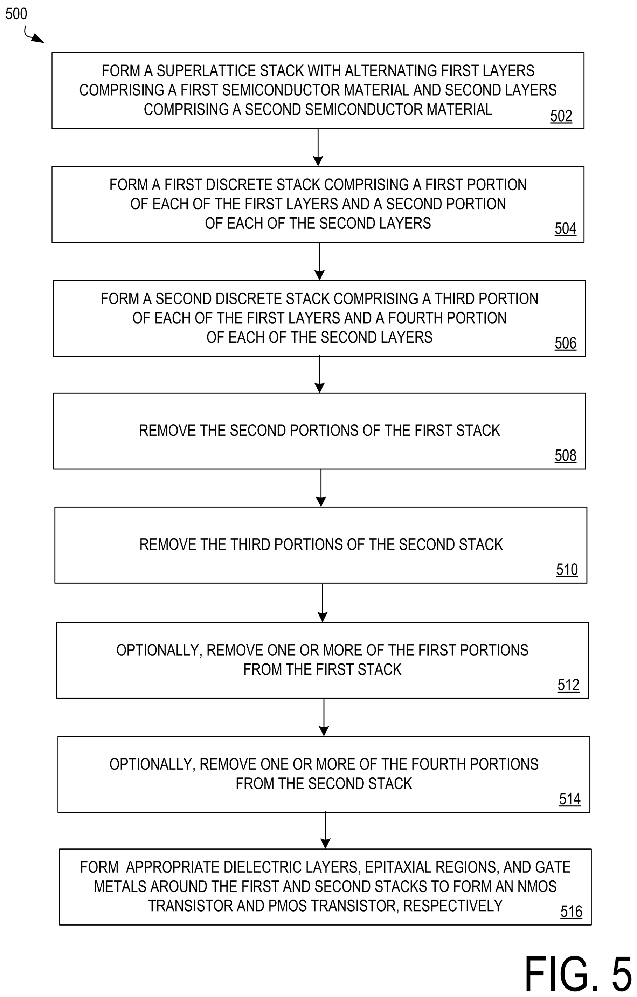

FIG. 5 is a first example method for forming a device assembly including adjacent NMOS and PMOS transistors in a hybrid CMOS architecture in accordance with the present disclosure. The example method 500 may include additional, fewer, or other operations than those shown. Additionally, the operations of method 500 can be performed in another order than shown. Furthermore, some of the operations shown or described as being separate may be performed simultaneously, while some of the operations shown or described as being performed at the same time may be performed at different times. The description of method 500 may reference, at times, various materials, layers, spaces, and other structures previously shown and described herein.

At 502, a superlattice stack (e.g., superlattice stacks 301, 401) is formed. The superlattice stack may include alternating first layers (e.g., first layers 302, 402) composed of a first semiconductor material and second layers (e.g., second layers 304, 404) composed of a second semiconductor material.

At 504 a first discrete stack (e.g., first discrete stack 311, 411) is formed. The first discrete stack comprises a first portion of each of the first layers and a second portion of each of the second layers.

At 506 a second discrete stack (e.g., second discrete stack 321, 421) is formed. The second discrete stack comprises a third portion of each of the first layers and a fourth portion of each of the second layers.

At 508, the second portions of the first stack are removed. For example, a nanoribbon process of etching may be used to remove the second portions.

At 510, the third portions of the second stack are removed. For example, a nanoribbon process of etching may be used to remove the third portions.

Optionally, at 512, one or more of the first portions may be removed from the first stack.

Optionally, at 514, one or more of the fourth portions may be removed from the first stack.

A nanoribbon process may be used to remove the various portions of the first and second layers from the first and second stacks. Thus, the desired nanoribbons are released.

At 516, appropriate additional layers (e.g., gate spacer layers 207, dimple spacer layers 209, epitaxial regions 208, upper layers 206, high-k dielectric layers 216, 316, 416 for NMOS transistors, high-k dielectric layers 226, 326, 426 for PMOS transistors) may be formed on the device assembly around the first and second stacks. In addition, appropriate gate metals (e.g., gate regions 215, 225, 315, 325, 415, 425) are added to the first and second stacks to form an NMOS transistor with the first stack and a PMOS transistor with the second stack.

The multi-layer magnetoelectric, ferroelectric, and ferromagnetic structures described herein (e.g., NMOS and PMOS transistors) can be used in any processor unit or integrated circuit component described or referenced herein. An integrated circuit component comprising multi-layer magnetoelectric, ferroelectric, or ferromagnetic structures can be attached to a printed circuit board. In some embodiments, one or more additional integrated circuit components or other components, such as a battery or antenna, can be attached to the printed circuit board. In some embodiments, the printed circuit board and the integrated circuit component can be located in a computing device that comprises a housing that encloses the printed circuit board and the integrated circuit component, and the integrated circuit component is an integrated circuit structure comprising devices that include magnetoelectric, ferroelectric, or ferromagnetic structures can comprise other types of devices, such as electronic transistors (transistors such as CMOS transistors that operate through control of the flow of electric current and that do not rely upon the switching of the magnetization of a layer or component for operation).

It is to be understood that drawings illustrate idealized versions of structure cross-sections. In actual cross-sections, the lines, layers, and other elements illustrated in the drawings can have shapes that vary from those illustrated. For example, surfaces illustrated as planar may possess undulations, bumps, or dishing features; sidewalls can have a taper to them; ninety-degree corners can be rounded; and lines, layers, and features can overlap more or less than illustrated.

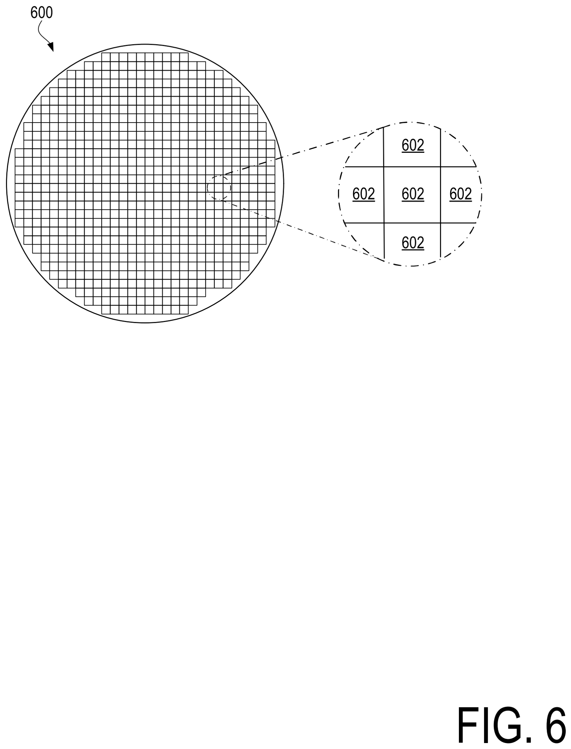

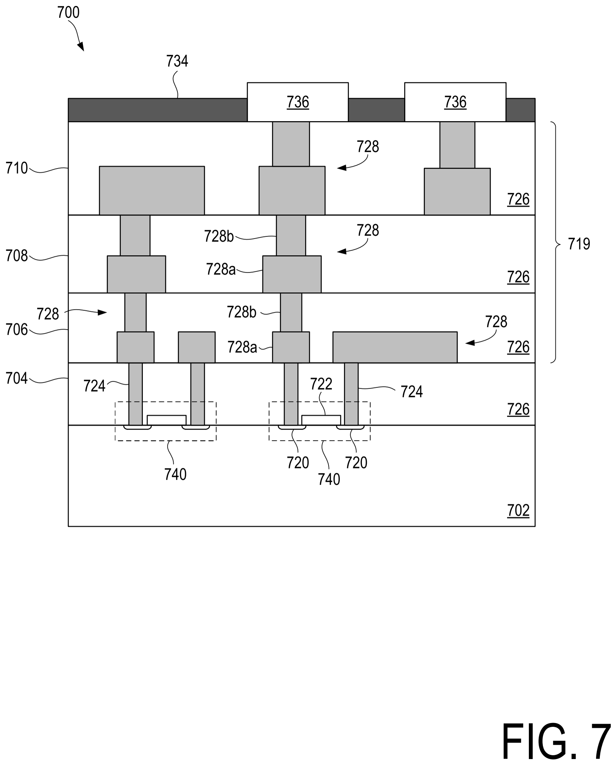

FIG. 6 is a top view of a wafer 600 and dies 602 that may incorporate any of the embodiments disclosed herein. The wafer 600 may be composed of semiconductor material and dies 602 having integrated circuit structures formed on a surface of the wafer 600. The individual dies 602 may be a repeating unit of an integrated circuit product that includes any suitable integrated circuit. After the fabrication of the semiconductor product is complete, the wafer 600 may undergo a singulation process in which the dies 602 are separated from one another to provide discrete "chips" of the integrated circuit product. The dies 602 may include one or more transistors (e.g., NMOS and PMOS transistors 210 and 220 of FIGS. 2A-2D, NMOS and PMOS transistors 310 and 320 of FIGS. 3A-3E, NMOS and PMOS transistors 410 and 420 of FIGS. 4A-4E, and/or transistors 740 of FIG. 7), supporting circuitry to route electrical signals to the transistors, passive components (e.g., signal traces, resistors, capacitors, or inductors), and/or any other integrated circuit components that can be fabricated on the wafer. In some embodiments, the wafer 600 or the dies 602 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), logic gates (e.g., AND, OR, NAND, and NOR gates), or any other suitable circuit element. Multiple ones of these devices and components may be combined on a single die. For example, a memory array formed by multiple memory devices may be formed on the same die as a processor unit or other logic configured to store information in the memory devices or execute instructions stored in the memory array. Various microelectronic assemblies (e.g., device assembly 200 in FIGS. 2A-2D, device assembly 350 in FIG. 3E, device assembly 450 in FIG. 4E) disclosed herein may be manufactured using a die-to-wafer assembly technique in which some dies are attached to a wafter 600 that include others of the dies, and the wafer 600 is subsequently singulated.

FIG. 7 is a cross-sectional view of an integrated circuit structure 700 that may be included in any of the microelectronic assemblies (e.g., device assemblies 200, 350, 450). Multiple instances of the integrated circuit structure 700 may be included in dies 602 (FIG. 6). The integrated circuit structure 700 may be formed on a die substrate 702. The die substrate 702 may be a semiconductor substrate composed of semiconductor material including, for example, n-type or p-type materials (or a combination of both). The die substrate 702 may include, for example, a crystalline substrate formed using a bulk silicon or a silicon-on-insulator (SOI) substructure. In some embodiments, the die substrate 702 can comprise a layer of silicon on top of an SOI layer with bulk silicon below the SOI layer. In some embodiments, the die substrate 702 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 702. Although a few examples of materials from which the die substrate 702 may be formed are described here, any material that may serve as a foundation for an integrated circuit structure 700 may be used. The die substrate 702 may be part of a singulated die (e.g., dies 602 of FIG. 6) or a wafer (e.g., wafer 600 of FIG. 6).

The integrated circuit structure 700 may include device layer 704 disposed on the die substrate 702. The device layer 704 may include features of transistors 740 (e.g., metal oxide semiconductor field-effect transistors (MOSFETs)) formed on the die substrate 702. The transistors 740 may include, for example, source and drain regions (source/drain or S/D regions 720), a gate 722 to control current flow between the S/D regions 720, and S/D contacts 724 to route electrical signals to and from the S/D regions 720. The transistors 740 may include additional features not depicted for the sake of clarity, such as device isolation regions, gate contacts, and the like. The transistors 740 are not limited to the type and configuration depicted in FIG. 7 and may include a wide variety of other types and configurations such as, for example, non-planar transistors, or a combination of planar and non-planar transistors. Non-planar transistors may include FinFET transistors, such as double-gate transistors or tri-gate transistors, and wrap-around or all-around gate transistors, such as nanoribbon, nanosheet, or nanowire transistors, and any of the GAA FinFet transistors disclosed herein (e.g., NMOS transistors 210, 310, 410, PMOS transistors 220, 320, 420).

Returning to FIG. 7, transistors 740 may include a gate 722 formed of at least two layers, a gate dielectric, and a gate electrode. The gate dielectric may include one or more layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal (e.g., for gate regions 225, 325, 425) or n-type work function metal (for gate regions 215, 315, 415), depending on whether the transistor is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For PMOS transistors, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For NMOS transistors, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, such as in the FinFET illustrated in FIG. 1B, the gate electrode may have an upside-down U-shape that includes a top portion substantially parallel to the surface of the die substrate 702 and two side portions that are substantially perpendicular to the top surface of the die substrate 702. In other embodiments, such as the planar FET illustrated in FIG. 1A, at least one of the metal layers that form the gate electrode may be a planar layer that is substantially parallel to the top surface of the die substrate 702 without side portions. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack (comprising the gate dielectric and the gate electrode) to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of sidewall spacer pairs may be used; for instance, two pairs, three pairs, or four pairs of sidewall spacers may be formed on opposing sides of the gate stack.

The S/D regions 720 may be formed within the die substrate 702 adjacent to the gate 722 of transistors 740. The S/D regions 720 may be formed using an implantation/diffusion process or an etching/deposition process, for example. In the former process, dopants such as boron, aluminum, antimony, phosphorous, or arsenic may be ion-implanted into the die substrate 702 to form the S/D regions 720. An annealing process that activates the dopants and causes them to diffuse further into the die substrate 702 may follow the ion implantation process. In the latter process, the die substrate 702 may first be etched to form recesses at the locations of the S/D regions 720. An epitaxial deposition process may then be carried out to fill the recesses with material that is used to fabricate the S/D regions 720. In some implementations, the S/D regions 720 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 720 may be formed using one or more alternate semiconductor materials such as germanium or a group III-V material or alloy. In further embodiments, one or more layers of metal and/or metal alloys may be used to form the S/D regions 720.

Electrical signals, such as power and/or information-carrying signals (e.g., input/output (I/O) signals, may be routed to and/or from devices (e.g., transistors 740) of the device layer 704 through one or more interconnect layers disposed on the device layer 704 (illustrated in FIG. 7 as interconnect layers 706-710). For example, electrically conductive features of the device layer 704 (e.g., the gate 722 and the S/D contacts 724) may be electrically coupled with interconnect structures 728 of the interconnect layers 706-710. The one or more interconnect layers 706-710 may form a metallization stack 719 (which can also be referred to as an "ILD stack" (inter-layer dielectric stack)) of the integrated circuit structure 700.

The interconnect structures 728 may be arranged within the interconnect layers 706-710 to route electrical signals according to a wide variety of designs; in particular, the arrangement is not limited to the particular configuration of interconnect structures 728 depicted in FIG. 7. Although a particular number of interconnect layers 706-710 is depicted in FIG. 7, embodiments of the present disclosure include integrated circuit structures having more or fewer interconnect layers than depicted.

In some embodiments, the interconnect structures 728 may include traces or lines 728a and/or vias 728b filled with an electrically conductive material such as a metal. The lines 728a may be arranged to route electrical signals in a direction of a plane that is substantially parallel with a surface of the die substrate 702 upon which the device layer 704 is formed. For example, the lines 728a may route electrical signals in a direction in and out of the page and/or in a direction across the page from the perspective of FIG. 7. The vias 728b may be arranged to route electrical signals in a direction of a plane that is substantially perpendicular to the surface of the die substrate 702 upon which the device layer 704 is formed. In some embodiments, lines 728a of different interconnect layers 706-710 are electrically coupled by vias 728b.

The interconnect layers 706-710 may include a dielectric material 726 within which the interconnect structures 728 are disposed, as shown in FIG. 7. In some embodiments, dielectric material 726 in different ones of the interconnect layers 706-710 may have different compositions; in other embodiments, the composition of the dielectric material 726 between different interconnect layers 706-710 may be the same. The device layer 704 may include a dielectric material 726 within which the transistors 740 are disposed and upon which a bottom layer of the metallization stack is located. The dielectric material 726 that is part of the device layer 704 may have a different composition than the dielectric material 726 included in the interconnect layers 706-710; in other embodiments, the composition of the dielectric material 726 in the device layer 704 may be the same as a dielectric material 726 included in any one of the interconnect layers 706-710.

A first interconnect layer 706 (which can be referred to as a Metal 1 or "M1" layer) may be formed directly on the device layer 704. In some embodiments, the first interconnect layer 706 may include lines 728a and/or vias 728b, as shown. The lines 728a of the first interconnect layer 706 may be coupled with contacts (e.g., the S/D contacts 724) of the device layer 704. The vias 728b of the first interconnect layer 706 may be coupled with the lines 728a of a second interconnect layer 708.

The second interconnect layer 708 (which can be referred to as a Metal 2 or "M2" layer) may be formed directly on the first interconnect layer 706. In some embodiments, the second interconnect layer 708 may include vias 728b to couple the lines 728a of the second interconnect layer 708 with the lines 728a of a third interconnect layer 710. Although the lines 728a and the vias 728b are structurally delineated with a line within individual interconnect layers for the sake of clarity, the lines 728a and the vias 728b may be structurally and/or materially contiguous (e.g., simultaneously filled during a dual-damascene process) in some embodiments.

The third interconnect layer 710 (which can be referred to as a Metal 3 or "M3" layer) (and additional interconnect layers, as desired) may be formed in succession on the second interconnect layer 708 according to similar techniques and configurations described in connection with the second interconnect layer 708 or the first interconnect layer 706. In some embodiments, the interconnect layers that are "higher up" in the metallization stack 719 in the integrated circuit structure 700 (i.e., farther away from the device layer 704) may be thicker than the interconnect layers that are lower in the metallization stack 719, with lines 728a and vias 728b in the higher interconnect layers being thicker than those in the lower interconnect layers.

The integrated circuit structure 700 may include a solder resist material 734 (e.g., polyimide or similar material) and conductive contacts 736 formed on the stack of interconnect layers 706-710. In FIG. 7, the conductive contacts 736 are illustrated as taking the form of bond pads. The conductive contacts 736 may be electrically coupled with interconnect structures 728 of the top-most layer in the metallization stack 719 and configured to route electrical signals between the transistors 740 and components external to the integrated circuit structure 700. For example, solder bonds may be formed on the conductive contacts 736 to mechanically and/or electrically couple an integrated circuit component comprising the integrated circuit structure 700 with another component (e.g., a printed circuit board). The integrated circuit structure 700 may include additional or alternate structures to route electrical signals from the interconnect layers 706-710; for example, the conductive contacts 736 may include other analogous features (e.g., posts) that can route the electrical signals between the transistors 740 and external components.

In some embodiments in which the integrated circuit structure 700 is part of a double-sided die, the integrated circuit structure 700 may include a second metallization stack (not shown) located on the opposite side of the die substrate 702 from the device layer 704. This second metallization stack may include multiple interconnect layers as discussed above with reference to the interconnect layers 706-710. Through-silicon vias (TSVs) that extend through the die substrate 702 can provide electrically conductive pathways from the transistors 740 to the second metallization stack and the second metallization stack can electrically couple the TSVs to additional conductive contacts (not shown) located on the opposite side of the integrated circuit structure 700 from the conductive contacts 736.

In some embodiments, TSVs extending through the die substrate 702 can be used for routing power and ground signals from conductive contacts located on the opposite side of the integrated circuit structure 700 from the conductive contacts 736 to the transistors 740 and any other components integrated into the integrated circuit structure 700, and the metallization stack 719 can be used to route information-carrying signals from the conductive contacts 736 to transistors 740 and any other components integrated into the integrated circuit structure 700. Put another way, the routing of power and ground signals to the transistors 740 can be separated (via a back-side or bottom-side metallization stack and TSVs) from the routing of information-carrying signals to the transistors. The power and ground signals are provided by a back-side or bottom-side metallization stack and TSVs, and information-carrying signals are provide by a top-side metallization stack (e.g., metallization stack 719).

Several integrated circuit dies may be stacked with one or more TSVs in the individual stacked dies providing connection between one of the dies to any of the other dies in the stack. For example, one or more high-bandwidth memory (HBM) integrated circuit dies can be stacked on top of a base integrated circuit die and TSVs in the HBM dies can provide connection between the individual HBM dies and the base integrated circuit die. Conductive contacts can provide additional connections between adjacent integrated circuit dies in the stack. In some embodiments, the conductive contacts can be fine-pitch solder bumps (microbumps).

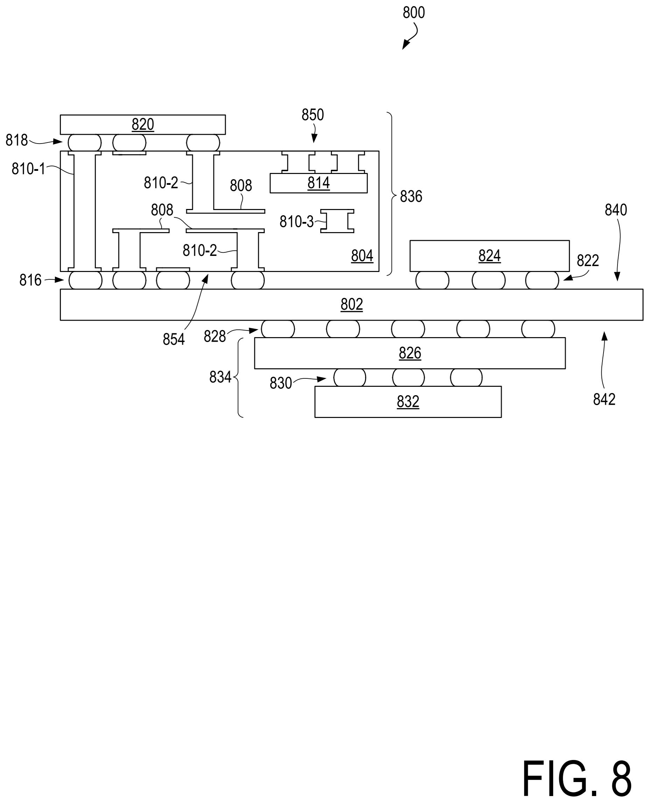

FIG. 8 is a cross-sectional view of an integrated circuit device assembly 800 that may include any of the microelectronic assemblies (e.g., device assemblies 200, 350, 450) disclosed herein. In some embodiments, the integrated circuit device assembly 800 may be a microelectronic assembly ###. The integrated circuit device assembly 800 includes a number of components disposed on a circuit board 802 (which may be a motherboard, system board, mainboard, etc.). The integrated circuit device assembly 800 includes components disposed on a first face 840 of the circuit board 802 and a second face 842 of the circuit board 802, the second face 842 opposing the first face 840. Generally, components may be disposed on either or both of the first face 840 and the second face 842 of the circuit board 802. Any of the integrated circuit components discussed below with reference to the integrated circuit device assembly 800 may take the form of or include any suitable ones of the embodiments of the microelectronic assemblies (e.g., device assemblies 200, 350, 450) disclosed herein.

In some embodiments, the circuit board 802 may be a printed circuit board (PCB) including multiple metal (or interconnect) layers separated from one another by layers of dielectric material and interconnected by electrically conductive vias. The individual metal layers comprise conductive traces. The metal layers may be formed in a desired pattern to route electrical signals between the components electrically coupled to the circuit board 802. In other embodiments, the circuit board 802 may be a non-PCB substrate.

The integrated circuit device assembly 800 illustrated in FIG. 8 includes a package-on-interposer structure 836 coupled to the first face 840 of the circuit board 802 by coupling components 816. The coupling components 816 may electrically and mechanically couple the package-on-interposer structure 836 to the circuit board 802 and may include solder balls (as shown in FIG. 8), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. (Thus, a coupling component may comprise a conductive contact.) The coupling components 816 may serve as the coupling components illustrated or described for any substrate assembly or substrate assembly components described herein (e.g., integrated circuit components), as appropriate.

The package-on-interposer structure 836 may include an integrated circuit component 820 coupled to an interposer 804. The interposer 804 may provide an intervening substrate used to bridge the circuit board 802 and the integrated circuit component 820. The integrated circuit component 820 is coupled to the interposer 804 by coupling components 818. The coupling components 818 may take any suitable form, such as the forms discussed above with reference to the coupling components 816. Although FIG. 8 shows just one integrated circuit component attached to the interposer, multiple integrated circuit components may be coupled to the interposer 804. Additional interposers may be coupled to the interposer 804.

The integrated circuit component 820 may be a packaged or unpacked integrated circuit product that includes one or more integrated circuit dies (e.g., the die 602 of FIG. 6, a die comprising the integrated circuit structure 700 of FIG. 7) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one unpackaged example of an integrated circuit component 820, a single monolithic integrated circuit die comprises solder bumps attached to contacts on the die. The solder bumps allow the die to be directly attached to the interposer 804. The integrated circuit component 820 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 820 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 820 comprises multiple integrated circuit dies, the dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 820 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 804 may spread connections to a wider or narrower pitch or reroute a connection to a different connection. For example, the interposer 804 may couple coupling components 818 having a first pitch to coupling components 816 having a wider pitch than the first pitch. In the embodiment illustrated in FIG. 8, the integrated circuit component 820 and the circuit board 802 are attached to opposing sides of the interposer 804. In other embodiments, the integrated circuit component 820 and the circuit board 802 may be attached to a same side of the interposer 804. In some embodiments, three or more components may be interconnected by way of the interposer 804.

In some embodiments, the interposer 804 may be formed as a PCB, including multiple metal layers separated from one another by layers of dielectric material and interconnected by electrically conductive vias. In some embodiments, the interposer 804 may be formed of an epoxy resin, a fiberglass-reinforced epoxy resin, an epoxy resin with inorganic fillers, a ceramic material, or a polymer material such as polyimide. In some embodiments, the interposer 804 may be formed of alternate rigid or flexible materials that may include the same materials described above for use in a semiconductor substrate, such as silicon, germanium, and other group III-V and group IV materials. The interposer 804 may include metal interconnects 808 and vias, including but not limited to through hole vias 810-1 (that extend from a first face 850 of the interposer 804 to a second face 854 of the interposer 804), blind vias 810-2 (that extend from the first face 850 or the second face 854 of the interposer 804 to an internal metal layer), and buried vias 810-3 (that connect internal metal layers).

In some embodiments, the interposer 804 can comprise a silicon interposer. Through silicon vias (TSV) extending through the silicon interposer can connect connections on a first face of a silicon interposer to an opposing second face of the silicon interposer. In some embodiments, an interposer 804 comprising a silicon interposer can further comprise one or more routing layers to route connections on a first face of the interposer 804 to an opposing second face of the interposer 804.

In some embodiments the interposer 804, as well as the circuit board 802, can comprise an amorphous solid layer of glass (which can be referred to a glass core or glass substrate). In some embodiments, the layer of glass can comprise silica (comprising silicon dioxide (SiO₂)), fused silica, aluminosilicate (comprising aluminum oxide (Al₂O₃) and silicon dioxide), borosilicate (comprising silicon dioxide and boron trioxide (B₂O₃)), or alumino-borosilicate (comprising aluminum oxide, silicon dioxide, and boron trioxide). In some embodiments, the layer of glass can comprise one or more of the following additives: aluminum oxide, boron trioxide, magnesium oxide (MgO), calcium oxide (CaO), strontium oxide (SrO), barium oxide (BaO), tin(IV) oxide (SnO₂), nitrous oxide (Na₂O), potassium oxide (K₂O), diphosphorous trioxide (P₂O₃), zirconium dioxide (ZrO₂), lithium oxide (Li₂O), titanium, and zinc. In some embodiments, the layer of glass can comprise silicon and oxygen, as well as one or more of aluminum, boron, magnesium, calcium, barium, tin, sodium, potassium, strontium, phosphorous, zirconium, lithium, titanium, and zinc. In some embodiments, the layer of glass comprises at least 23 percent silicon by weight, at least 26 percent oxygen by weight, and at least five percent aluminum by weight. In some embodiments, the layer of glass does not include an organic adhesive or an organic material. For example, the layer of glass is not a substrate or a board comprising glass fibers and an epoxy binder, such as a printed circuit board (PCB) comprising multiple metal (or interconnect) layers separated from one another by layers of dielectric material (e.g., FR-4 or other fiberglass-reinforced epoxy laminate) and interconnected by electrically conductive vias.

In some embodiments, the glass layer has a thickness in the range of about 50 microns to about 1.4 millimeters. In some embodiments, the glass layer is or is part of a multi-layer glass substrate (a coreless substrate). Individual glass layers in a multi-layer glass substrate can have a thickness in the range of about 25 microns to about 50 microns. In some embodiments, a glass layer can have a length in the range of about 10 millimeters to about 250 millimeters on a side (e.g., can have an area in the range of about 10 mm x 10 mm to about 250 mm x 250 mm). In some embodiments, the glass layer comprises a rectangular prism volume with sections or portions (e.g., through-glass vias) removed and filled with other metals (e.g., metal).

In some embodiments, redistribution layers (RDL) can be located on either or both sides of the glass layer to provide electrically conductive paths from top and/or bottom surfaces of the interposer 804 or circuit board 802 to the glass layer. The glass layer can comprise through-glass vias (TGVs) that extend through the glass layer to provide electrically conductive paths through the glass core, glass substrate, or glass layer.

The interposer 804 may further include embedded devices 814, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 804. The package-on-interposer structure 836 may take the form of any of the package-on-interposer structures known in the art.

The integrated circuit device assembly 800 may include an integrated circuit component 824 coupled to the first face 840 of the circuit board 802 by coupling components 822. The coupling components 822 may take the form of any of the embodiments discussed above with reference to the coupling components 816, and the integrated circuit component 824 may take the form of any of the embodiments discussed above with reference to the integrated circuit component 820.

The integrated circuit device assembly 800 illustrated in FIG. 8 further includes a package-on-package structure 834 coupled to the second face 842 of the circuit board 802 by coupling components 828. The package-on-package structure 834 may include an integrated circuit component 826 and an integrated circuit component 832 coupled together by coupling components 830 such that the integrated circuit component 826 is disposed between the circuit board 802 and the integrated circuit component 832. The coupling components 828 and 830 may take the form of any of the embodiments of the coupling components 816 discussed above, and the integrated circuit components 826 and 832 may take the form of any of the embodiments of the integrated circuit component 820 discussed above. The package-on-package structure 834 may be configured in accordance with any of the package-on-package structures known in the art.

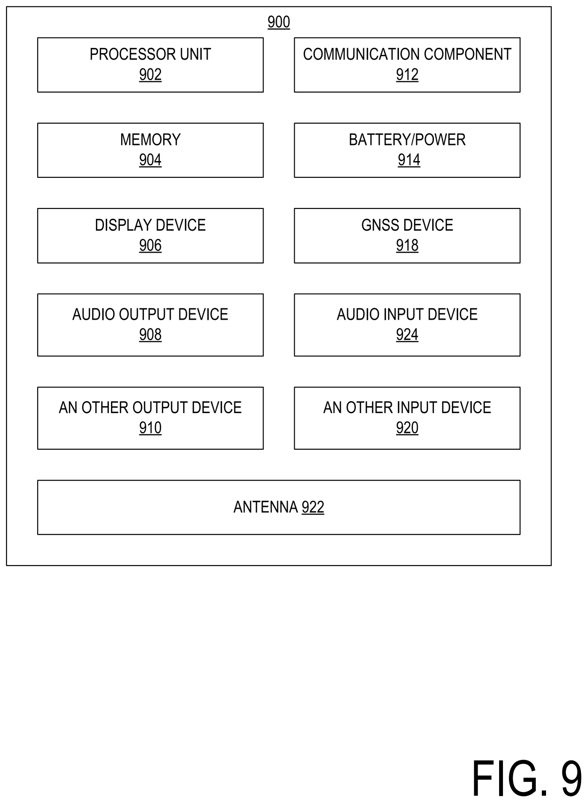

FIG. 9 is a block diagram of an example electrical device 900 that may include any of the microelectronic assemblies disclosed herein. For example, any suitable ones of the components of the electrical device 900 may include one or more of the integrated circuit device assembly 800, integrated circuit component 820, or integrated circuit structure 700, integrated circuit dies 602 disclosed herein, and may be arranged in any of the microelectronic assemblies (e.g., device assemblies 200, 350, 450) disclosed herein. A number of components are illustrated in FIG. 9 as included in the electrical device 900, but any one or more of these components may be omitted or duplicated, as suitable for the application. In some embodiments, some or all of the components included in the electrical device 900 may be attached to one or more motherboards mainboards, or system boards. In some embodiments, one or more of these components are fabricated onto a single system-on-a-chip (SoC) die.

Additionally, in various embodiments, the electrical device 900 may not include one or more of the components illustrated in FIG. 9, but the electrical device 900 may include interface circuitry for coupling to the one or more components. For example, the electrical device 900 may not include a display device 906, but may include display device interface circuitry (e.g., a connector and driver circuitry) to which a display device 906 may be coupled. In another set of examples, the electrical device 900 may not include an audio input device 924 or an audio output device 908, but may include audio input or output device interface circuitry (e.g., connectors and supporting circuitry) to which an audio input device 924 or audio output device 908 may be coupled.

The electrical device 900 may include one or more processor units 902. As used herein, the terms "processor unit," "processing unit," or "processor" may refer to any device or portion of a device that processes electronic data from registers and/or memory to transform that electronic data into other electronic data that may be stored in registers and/or memory. The one or more processor units 902 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 900 may include a memory 904, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 904 may include memory that is located on the same integrated circuit die as the one or more processor units 902. This memory may be used as cache memory (e.g., Level 1 (L1), Level 2 (L2), Level 3 (L3), Level 4 (L4), Last Level Cache (LLC)) and may include embedded dynamic random-access memory (eDRAM) or spin transfer torque magnetic random-access memory (STT-MRAM).

In some embodiments of the electrical device 900, a first one of the one or more processor units 902 can be heterogeneous or asymmetric to a second one of the one or more processor units 902 in the electrical device 900. There can be a variety of differences between the one or more processor units 902 in a system in terms of a spectrum of metrics of merit including architectural, microarchitectural, thermal, power consumption characteristics, and the like. These differences can effectively manifest themselves as asymmetry and heterogeneity among the one or more processor units 902 in the electrical device 900.

In some embodiments, the electrical device 900 may include a communication component 912. For example, the communication component 912 can manage wireless communications for the transfer of data to and from the electrical device 900. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 912 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 912 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 912 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 912 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 912 may operate in accordance with other wireless protocols in other embodiments. The electrical device 900 may include an antenna 922 to facilitate wireless communications and/or to receive other wireless communications (such as AM or FM radio transmissions).

In some embodiments, the communication component 912 may manage wired communications, such as electrical, optical, or any other suitable communication protocols (e.g., IEEE 802.3 Ethernet standards). In some embodiments, the electrical device 900 comprises multiple communication components. For instance, a first communication component may be dedicated to shorter-range wireless communications such as Wi-Fi or Bluetooth, and a second communication component may be dedicated to longer-range wireless communications such as global positioning system (GPS), EDGE, GPRS, CDMA, WiMAX, LTE, EV-DO, or others. In some embodiments, a first communication component may be dedicated to wireless communications, and a second communication component may be dedicated to wired communications.

The electrical device 900 may include battery/power circuitry 914. The battery/power circuitry 914 may include one or more energy storage devices (e.g., batteries or capacitors) and/or circuitry for coupling components of the electrical device 900 to an energy source separate from the electrical device 900 (e.g., AC line power).

The electrical device 900 may include a display device 906 (or corresponding interface circuitry, as discussed above). The display device 906 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 900 may include an audio output device 908 (or corresponding interface circuitry, as discussed above). The audio output device 908 may include any embedded or wired or wirelessly connected external device that generates an audible indicator, such as speakers, headsets, or earbuds.

The electrical device 900 may include an audio input device 924 (or corresponding interface circuitry, as discussed above). The audio input device 924 may include any embedded or wired or wirelessly connected device that generates a signal representative of a sound, such as microphones, microphone arrays, or digital instruments (e.g., instruments having a musical instrument digital interface (MIDI) output). The electrical device 900 may include a Global Navigation Satellite System device (GNSS) (or corresponding interface circuitry, as discussed above), such as a Global Positioning System (GPS) device. The GNSS device 918 may be in communication with a satellite-based system and may determine a geolocation of the electrical device 900 based on information received from one or more GNSS satellites, as known in the art.

The electrical device 900 may include another output device 910 (or corresponding interface circuitry, as discussed above). Examples of the other output device 910 may include an audio codec, a video codec, a printer, a wired or wireless transmitter for providing information to other devices, or an additional storage device.

The electrical device 900 may include another input device 920 (or corresponding interface circuitry, as discussed above). Examples of the other input device 920 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 900 may have any form factor, such as a hand-held or mobile electrical device (e.g., a cell phone, a smartphone, a mobile internet device, a music player, a tablet computer, a laptop computer, a 2-in-1 convertible computer, a portable all-in-one computer, a netbook computer, an ultrabook computer, a personal digital assistant (PDA), an ultra-mobile personal computer, a portable gaming console), a desktop electrical device, a server, a rack-level computing solution (e.g., blade, tray, or sled computing system), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 900 may be any other electronic device that processes data. In some embodiments, the electrical device 900 may comprise multiple discrete physical components. Given the range of devices that the electrical device 900 can be manifested as in various embodiments, in some embodiments, the electrical device 900 can be referred to as a computing device or a computing system.

As used in this specification, the term "connected" may indicate elements are in direct physical or electrical contact with each other and "coupled" may indicate elements cooperate or interact with each other, but they may or may not be in direct physical or electrical contact. Furthermore, the terms "comprising," "including," "having," and the like, as used with respect to embodiments of the present disclosure, are synonymous. Terms modified by the word "substantially" include arrangements, orientations, spacings, or positions that vary slightly from the meaning of the unmodified term. For example, horizontal axis substantially parallel to another horizontal axis includes axes that are within a few degrees (e.g., +/- 10 degrees) of 180 degrees.

As used herein, the phrase "located on" in the context of a first layer or component located on a second layer or component refers to the first layer or component being directly physically attached to the second part or component (no layers or components between the first and second layers or components) or physically attached to the second layer or component with one or more intervening layers or components. For example, with reference to FIG. 3B, the upper layer located on the epitaxial region is in contact with the epitaxial region or is attached to the epitaxial region with one or more intervening layers or components. As used herein, the term "adjacent" refers to layers or components that are arranged next to each other (e.g., side-by-side, top and bottom).

Certain terminology may also be used herein for the purpose of reference only, and thus are not intended to be limiting. For example, terms such as "upper," "lower," "above," "below," "bottom," and "top" refer to directions in the Figures to which reference is made. Terms such as "front," "back," "rear," and "side" describe the orientation and/or location of layers, components, portions of components, etc., within a consistent but arbitrary frame of reference, which is made clear by reference to the text and the associated Figures describing the layers, component, portions of components, etc. under discussion. Such terminology may include the words specifically mentioned above, derivatives thereof, and words of similar import.

As used herein, the term "integrated circuit component" refers to a packaged or unpacked integrated circuit product. A packaged integrated circuit component comprises one or more integrated circuit dies mounted on a package substrate with the integrated circuit dies and package substrate encapsulated in a casing material, such as a metal, plastic, glass, or ceramic. In one example, a packaged integrated circuit component contains one or more processor units mounted on a substrate with an exterior surface of the substrate comprising a solder ball grid array (BGA). In one example of an unpackaged integrated circuit component, a single monolithic integrated circuit die comprises solder bumps attached to contacts on the die. The solder bumps allow the die to be directly attached to a printed circuit board. An integrated circuit component can comprise one or more of any computing system component described or referenced herein or any other computing system component, such as a processor unit (e.g., system-on-a-chip (SoC), processor core, graphics processor unit (GPU), accelerator, chipset processor), I/O controller, memory, or network interface controller.

As used herein, the phrase "electrically coupled" refers to the presence of one or more electrically conductive paths between components that are recited as being electrically coupled.

A TIM layer can be any suitable material, such as a silver thermal compound, thermal grease, phase change materials, indium foils, or graphite sheets. A cold plate can be any suitable type of cold plate, such as a tubed cold plate or a cold plate comprising internal fins or channels (e.g., microchannels), and be made of any suitable material, such as copper, aluminum, or stainless steel that is chemically compatible with immersion and working fluids.

As used in this application and the claims, a list of items joined by the term "and/or" can mean any combination of the listed items. For example, the phrase "A, B, and/or C" can mean A; B; C; A and B; A and C; B and C; or A, B and C. As used in this application and the claims, a list of items joined by the term "at least one of" can mean any combination of the listed terms. For example, the phrase "at least one of A, B, or C" can mean A; B; C; A and B; A and C; B and C; or A, B, and C. Moreover, as used in this application and the claims, a list of items joined by the term "one or more of" can mean any combination of the listed terms. For example, the phrase "one or more of A, B, and C" can mean A; B; C; A and B; A and C; B and C; or A, B, and C.

As used in this application and the claims, the phrase "individual of" or "respective of" following by a list of items recited or stated as having a trait, feature, etc. means that all of the items in the list possess the stated or recited trait, feature, etc. For example, the phrase "individual of A, B, or C, comprise a sidewall" or "respective of A, B, or C, comprise a sidewall" means that A comprises a sidewall, B comprises sidewall, and C comprises a sidewall.

The disclosed methods, apparatuses, and systems are not to be construed as limiting in any way. Instead, the present disclosure is directed toward all novel and nonobvious features and aspects of the various disclosed embodiments, alone and in various combinations and subcombinations with one another. The disclosed methods, apparatuses, and systems are not limited to any specific aspect or feature or combination thereof, nor do the disclosed embodiments require that any one or more specific advantages be present or problems be solved.

Theories of operation, scientific principles, or other theoretical descriptions presented herein in reference to the apparatuses or methods of this disclosure have been provided for the purposes of better understanding and are not intended to be limiting in scope. The apparatuses and methods in the appended claims are not limited to those apparatuses and methods that function in the manner described by such theories of operation.

Although the operations of some of the disclosed methods are described in a particular, sequential order for convenient presentation, it is to be understood that this manner of description encompasses rearrangement, unless a particular ordering is required by specific language set forth herein. For example, operations described sequentially may in some cases be rearranged or performed concurrently. Moreover, for the sake of simplicity, the attached figures may not show the various ways in which the disclosed methods can be used in conjunction with other methods.

The following examples pertain to additional embodiments of technologies disclosed herein.

Example A1 provides an apparatus that comprises: a first transistor on a base layer and a second transistor on a base layer, and the first transistor includes first channel regions including a first element, a first gate region around the first channel regions, and a first source region and a first drain region at opposite ends of the first channel regions; and the second transistor includes second channel regions includes a second element, a second gate region around the second channel regions, and a second source region and a second drain region at opposite ends of the second channel regions, and the first channel regions are in first planes, respectively, and the second channel regions are in second planes, respectfully, and the first planes are axially spaced from the second planes.

Example A2 comprises the subject matter of Example A1, and a first number of the first channel regions equals a second number of the second channel regions.

Example A3 comprises the subject matter of Example A1, and a first number of the first channel regions is less than a second number of the second channel regions.

Example A4 comprises the subject matter of any one of Examples A1-A3, and a first stack includes the first channel regions and a second stack includes the second channel regions, and a first height of the first stack is unequal to a second height of the second stack.

Example A5 comprises the subject matter of any one of Examples A1-A4, and the first element is silicon.

Example A6 comprises the subject matter of any one of Examples A1-A5, and the second element is one of germanium, silicon-germanium, and germanium-tin.

Example A7 comprises the subject matter of any one of Examples A1-A6, and the first gate region includes a p-type work function metal, and the second gate region includes an n-type work function metal.

Example A8 comprises the subject matter of any one of Examples A1-A7, and further comprises one or more memory devices; and one or more processor units.

Example B1 provides an integrated circuit device that comprises a substrate that includes silicon; a first gate-all-around (GAA) transistor on the substrate and a second GAA transistor on the substrate, and the first GAA transistor includes a first plurality of channel regions in a first stack, and the second GAA transistor includes a second plurality of channel regions in a second stack, and the first plurality of channel regions of the first GAA transistor are not coplanar with the second plurality of channel regions of the second GAA transistor.

Example B2 comprises the subject matter of Example B1, and a first height of the first stack is greater than a second height of the second stack.

Example B3 comprises the subject matter any one of Examples B1-B2, and a first number of channel regions in the first stack is equal to a second number of channel regions in the second stack.

Example B4 comprises the subject matter any one of Examples B1-B2, and a first number of channel regions in the first stack is greater than a second number of channel regions in the second stack.

Example B5 comprises the subject matter of any one of Examples B1-B4, and the first GAA transistor further includes a first gate region comprising a p-type work function metal, and the second GAA transistor further includes a second gate region comprising an n-type work function metal.

Example B6 comprises the subject matter any one of Examples B1-B5, and the first plurality of channel regions is composed of a first semiconductor material, and the second plurality of channel regions is composed of a second semiconductor material.

Example B7 is a processor unit that comprises the integrated circuit device of any one of Examples B1-B6.

Example B8 is a computing device that comprises a housing, and the housing encloses the integrated circuit device of any one of Examples B1-B7.

M1 provides a method that comprises: forming a first plurality of channels for a first transistor on a layer comprising silicon, and the first plurality of channels are composed of a first semiconductor material; and forming a second plurality of channels for a second transistor on the layer comprising silicon, and the second plurality of channels are composed of a second semiconductor material, and the first plurality of channels and the second plurality of channels are asymmetrically aligned on opposite sides of a space defined therebetween.

Example M2 comprises the subject matter of Example M1, and forming the first plurality of channels comprises: forming a first stack including a plurality of first portions of a plurality of first layers, respectively, and a plurality of second portions of a plurality of second layers, respectively; and removing the plurality of second portions from the first stack, and the plurality of first layers is composed of the first semiconductor material and the plurality of second layers is composed of the second semiconductor material.

Example M3 comprises the subject matter of Example M2, and further comprises removing at least one first portion of the plurality of first portions from the first stack.

Example M4 comprises the subject matter of any one of Examples M1-M3, and forming the second plurality of channels comprises: forming a second stack including a plurality of third portions of the plurality of first layers, respectively, and a plurality of fourth portions of the plurality of second layers, respectively; and removing the plurality of third portions from the second stack.

Example M5 comprises the subject matter any one of Examples M1-M4, and the first semiconductor material is silicon.

Example M6 comprises the subject matter of any one of Examples M1-M5, and the second semiconductor material is one of germanium, silicon-germanium, and germanium-tin.

## Claims

1. An apparatus comprising:
a first transistor on a base layer, the first transistor including:
first channel regions including a first element;
a first gate region around the first channel regions; and
a first source region and a first drain region at opposite ends of the first channel regions; and
a second transistor on the base layer, the second transistor including:
second channel regions including a second element;
a second gate region around the second channel regions; and
a second source region and a second drain region at opposite ends of the second channel regions, wherein the first channel regions are in first planes, respectively, and the second channel regions are in second planes, respectfully, wherein the first planes are axially spaced from the second planes.

2. The apparatus of Claim 1, wherein a first number of the first channel regions equals a second number of the second channel regions.

3. The apparatus of Claim 1, wherein a first number of the first channel regions is less than a second number of the second channel regions.

4. The apparatus of any one of Claims 1-3, wherein a first stack includes the first channel regions and a second stack includes the second channel regions, wherein a first height of the first stack is unequal to a second height of the second stack.

5. The apparatus of any one of Claims 1-4, wherein the first element is silicon.

6. The apparatus of any one of Claims 1-5, wherein the second element is one of germanium, silicon-germanium, and germanium-tin.

7. The apparatus of any one of Claims 1-6, wherein the first gate region includes a p-type work function metal, and wherein the second gate region includes an n-type work function metal.

8. The apparatus of any one of Claims 1-7, further comprising:
one or more memory devices; and
one or more processor units.

9. The apparatus of any one of Claims 1-8, wherein the apparatus includes an integrated circuit device comprising:
a substrate comprising silicon, wherein the first transistor is a first gate-all-around (GAA) transistor on the substrate, and wherein the second transistor is a second GAA transistor on the substrate.

10. A computing device comprising a housing, wherein the housing encloses the apparatus of any one of Claims 1-9.

11. A method comprising:
forming a first plurality of channels for a first transistor on a base layer comprising silicon, wherein the first plurality of channels are composed of a first semiconductor material; and
forming a second plurality of channels for a second transistor on the base layer, wherein the second plurality of channels are composed of a second semiconductor material, wherein the first plurality of channels and the second plurality of channels are asymmetrically aligned on opposite sides of a space defined therebetween.

12. The method of Claim 11, wherein forming the first plurality of channels comprises:
forming a first stack including a plurality of first portions of a first plurality of layers, respectively, and a plurality of second portions of a second plurality of layers, respectively, wherein the first plurality of layers is composed of the first semiconductor material and the second plurality of layers is composed of the second semiconductor material; and
removing the plurality of second portions from the first stack.

13. The method of Claim 12, further comprising:
removing at least one first portion of the plurality of first portions from the first stack.

14. The method of any one of Claims 12-13, wherein forming the second plurality of channels comprises:
forming a second stack including a plurality of third portions of the first plurality of layers, respectively, and a plurality of fourth portions of the second plurality of layers, respectively; and
removing the plurality of third portions from the second stack.

15. The method of any one of Claims 11-14, wherein the first semiconductor material is silicon, wherein the second semiconductor material is one of germanium, silicon-germanium, and germanium-tin.
